(19) **Europäisches Patentamt / European Patent Office / Office européen des brevets**

(11) **EP 3 938 138 B1**

(12) **EUROPEAN PATENT SPECIFICATION**

(45) Date of publication and mention
of the grant of the patent:
**12.11.2025  Bulletin 2025/46**

(21) Application number: **20822593.8**

(22) Date of filing: **29.05.2020**

(51) International Patent Classification (IPC):
**B23K 26/386** $^{(2014.01)}$    **H05K 3/00** $^{(2006.01)}$
**G02F 1/33** $^{(2006.01)}$    **B23K 26/0622** $^{(2014.01)}$
**B23K 26/082** $^{(2014.01)}$    **B23K 26/067** $^{(2006.01)}$

(52) Cooperative Patent Classification (CPC):
**H05K 3/0038; B23K 26/0624; B23K 26/0673;
B23K 26/082; B23K 26/386; G02F 1/33**

(86) International application number:
**PCT/US2020/035152**

(87) International publication number:
**WO 2020/251782 (17.12.2020 Gazette 2020/51)**

(54) **LASER PROCESSING APPARATUS, METHODS OF OPERATING THE SAME, AND METHODS OF PROCESSING WORKPIECES USING THE SAME**

**LASERBEARBEITUNGSVORRICHTUNG, VERFAHREN ZUM BETRIEB DAVON UND VERFAHREN ZUR BEARBEITUNG VON WERKSTÜCKEN UNTER VERWENDUNG DAVON**

**APPAREIL DE TRAITEMENT LASER, PROCÉDÉS DE FONCTIONNEMENT DUDIT APPAREIL ET PROCÉDÉS DE TRAITEMENT DE PIÈCES À L'AIDE DUDIT APPAREIL**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.06.2019  US 201962859572 P
04.11.2019  US 201962930287 P
05.02.2020  US 202062970648 P
18.05.2020  US 202063026564 P**

(43) Date of publication of application:
**19.01.2022  Bulletin 2022/03**

(73) Proprietor: **Electro Scientific Industries, Inc.
Beaverton OR 97005 (US)**

(72) Inventors:
• **KLEINERT, Jan**
  **Beaverton, OR 97005 (US)**
• **LIN, Zhibin**
  **Beaverton, OR 97005 (US)**
• **SCHRAUBEN, Joel**
  **Beaverton, OR 97005 (US)**
• **UNRATH, Mark**
  **Beaverton, OR 97005 (US)**
• **HU, Honghua**
  **Beaverton, OR 97005 (US)**
• **CHEN, Ruolin**
  **Beaverton, OR 97005 (US)**
• **YANG, Chuan**
  **Beaverton, OR 97005 (US)**
• **LOTT, Geoffrey**
  **Beaverton, OR 97005 (US)**
• **FINN, Daragh**
  **Beaverton, OR 97005 (US)**

(74) Representative: **HGF
HGF Limited
1 City Walk
Leeds LS11 9DX (GB)**

(56) References cited:
**WO-A1-2017/044646      JP-A- 2003 136 270
JP-A- 2010 207 881      JP-B1- 6 451 903**

## Description

I. Technical Field

Embodiments of the present invention relate to apparatus and techniques for laser-processing workpieces, and more particular to a method of forming a feature within a workpiece, to an apparatus, and to a controller for use with an apparatus for forming a feature within a workpiece, see claims 1, 14 and 15 respectively.

II. Discussion of the Related Art

Laser processes are often employed to form blind- and through-vias (typically <150 $\mu$m diameter) in workpieces such as printed circuit boards (both rigid and flexile varieties), and the like. An example of a laser process is disclosed in WO/2017/044646. To form a via, laser processes that may be used is a so-called "punch" process, a "trepan" process, or some combination thereof. During a punch process, a beam of laser energy is directed onto the workpiece is kept stationary while the via is formed. In contrast, during a trepan process, the beam of laser energy is moved relative to the workpiece to form the via. Conventionally, during a trepan process, the beam of laser energy is moved so as to scan a spot illuminated on the workpiece by the beam of laser energy in a spiral or circular pattern.

SUMMARY

According to a first aspect of the present invention, a method of forming a feature within a workpiece is defined in claim 1.

According to a second aspect of the present invention, an apparatus is defined in claim 14.

According to a third aspect of the present invention, a controller for use with an apparatus for forming a feature within a workpiece is defined in claim 15.

Further preferred embodiments of the present invention are defined in the dependent claims.

## BRIEF DESCRIPTION OF THE DRAWINGS

FIGS. 1 and 31 schematically illustrates laser-processing apparatuses according to some embodiments of the present invention.

FIG. 2 schematically illustrates a multi-axis AOD system that may be incorporated into the first positioner, according to one embodiment.

FIGS. 3 and 4 schematically illustrate techniques for implementing pulse slicing, according to some embodiments.

FIG. 5 is a cross-sectional view schematically illustrating an embodiment of a workpiece that may be processed by the laser-processing apparatus.

FIGS. 6 and 7 are cross-sectional views schematically illustrating embodiments of features that can be formed in the workpiece discussed with respect to FIG. 5, using the laser-processing apparatus.

FIGS. 8 to 22 and 24(a) are diagrams illustrating example embodiments of scan patterns, along which a process spot illuminated by a beam of laser energy directed onto the workpiece discussed with respect to FIG. 5 can be scanned, to form features such as those discussed with respect to FIGS. 6 and 7.

FIGS. 23, 24(b), 25 and 26 are photomicrographs of blind-vias formed in a workpiece (e.g., as shown in FIG. 6) upon scanning a process spot along the scan patterns shown in FIGS. 14, 24(a), 16 and 15, respectively. In FIGS. 23 and 24(b), the diameter, d, of the blind-vias is about 100 $\mu$m. In FIG. 25, the diameter, d, of the blind-via is about 75 $\mu$m. In FIG. 26, the diameter, d, of each blind-via is about 180 $\mu$m.

FIG. 27 is a diagram schematically illustrating a plan view of the shape of a via opening formed by scanning a process spot along a second-type scan pattern.

FIG. 28 is a diagram illustrating an exemplary circular arrangement of spot locations that, when scanned by a beam of laser energy, produce a via having an elliptical opening, as exemplarily shown in FIG. 27.

FIG. 29 is a diagram illustrating an exemplary elliptical arrangement of spot locations that, when scanned by a beam of laser energy, produce a via having an opening shape with higher circularity than the opening shape shown in FIG. 27.

FIG. 30 is a set of diagrams illustrating a technique for implementing pulse slicing during formation of a blind via, according to one embodiment.

FIGS. 32-45 are diagrams illustrating a technique for implementing pulse slicing during to form various features, according to some embodiments.

FIGS. 46, 48 and 49 are photomicrographs of via openings formed according to some embodiments of the present invention.

FIGS. 47, 50 and 51 diagrams illustrating techniques for forming vias having an opening resembling that shown in FIG. 48.

## DETAILED DESCRIPTION

Example embodiments are described herein with reference to the accompanying drawings. Unless otherwise expressly stated, in the drawings the sizes, positions, etc., of components, features, elements, etc., as well as any distances therebetween, are not necessarily to scale, but are exaggerated for clarity. In the drawings, like numbers refer to like elements throughout. Thus, the same or similar numbers may be described with reference to other drawings even if they are neither mentioned nor described in the corresponding drawing. Also, even elements that are not denoted by reference numbers may be described with reference to other drawings.

The terminology used herein is for the purpose of describing particular example embodiments only and is not intended to be limiting. Unless otherwise defined, all terms (including technical and scientific terms) used herein have the same meaning as commonly understood by one of ordinary skill in the art. As used herein, the singular forms "a," "an" and "the" are intended to include the plural forms as well, unless the context clearly indicates otherwise. It should be recognized that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Unless otherwise specified, a range of values, when recited, includes both the upper and lower limits of the range, as well as any sub-ranges therebetween. Unless indicated otherwise, terms such as "first," "second," etc., are only used to distinguish one element from another. For example, one node could be termed a "first node" and similarly, another node could be termed a "second node", or vice versa.

Unless indicated otherwise, the term "about," "thereabout," etc., means that amounts, sizes, formulations, parameters, and other quantities and characteristics are not and need not be exact, but may be approximate and/or larger or smaller, as desired, reflecting tolerances, conversion factors, rounding off, measurement error and the like, and other factors known to those of skill in the art. Spatially relative terms, such as "below," "beneath," "lower," "above," and "upper," and the like, may be used herein for ease of description to describe one element or feature's relationship to another element or feature, as illustrated in the FIGS. It should be recognized that the spatially relative terms are intended to encompass different orientations in addition to the orientation depicted in the FIGS. For example, if an object in the FIGS. is turned over, elements described as "below" or "beneath" other elements or features would then be oriented "above" the other elements or features. Thus, the exemplary term "below" can encompass both an orientation of above and below. An object may be otherwise oriented (e.g., rotated 90 degrees or at other orientations) and the spatially relative descriptors used herein may be interpreted accordingly.

The section headings used herein are for organizational purposes only and, unless explicitly stated otherwise, are not to be construed as limiting the subject matter described. It will be appreciated that many different forms, embodiments and combinations are possible without deviating from the spirit and teachings of this disclosure and so this disclosure should not be construed as limited to the example embodiments set forth herein. Rather, these examples and embodiments are provided so that this disclosure will be thorough and complete, and will convey the scope of the disclosure to those skilled in the art.

I. Overview

Embodiments described herein relate generally to methods and apparatuses for laser-processing (or, more simply, "processing") a workpiece. Generally the processing is accomplished, either in whole or in part, by irradiating the workpiece with laser radiation, to heat, melt, evaporate, ablate, crack, discolor, polish, roughen, carbonize, foam, or otherwise modify one or more properties or characteristics of one or more materials from which the workpiece is formed (e.g., in terms of chemical composition, atomic structure, ionic structure, molecular structure, electronic structure, microstructure, nanostructure, density, viscosity, index of refraction, magnetic permeability, relative permittivity, texture, color, hardness, transmissivity to electromagnetic radiation, or the like or any combination thereof). Materials to be processed may be present at an exterior of the workpiece prior to or during processing, or may be located completely within the workpiece (i.e., not present at an exterior of the workpiece) prior to or during processing.

Specific examples of processes that may be carried by the disclosed apparatus for laser processing, and which are described in greater detail below, include via drilling or other hole formation. It will be appreciated that the embodiments described herein may be extended to perform or otherwise facilitate cutting, perforating, welding, scribing, engraving, marking (e.g., surface marking, sub-surface marking, etc.), laser-induced forward transfer, cleaning, bleaching, bright pixel repair (e.g., color filter darkening, modification of OLED material, etc.), decoating, surface texturing (e.g., roughening, smoothing, etc.), or the like or any combination thereof. Thus, one or more features on that may be formed on or within a workpiece, as a result of the processing, can include openings, slots, vias or other holes, grooves, trenches, scribe lines, kerfs, recessed regions, conductive traces, ohmic contacts, resist patterns, human- or machine-readable indicia (e.g., comprised of one or more regions in or on the workpiece having one or more visually or texturally distinguishing characteristics), or the like or any combination thereof. Features such as openings, slots, vias, holes, etc.. can have any suitable or desirable shape (e.g., circular, elliptical, square, rectangular, triangular, annular, or the like or any combination thereof) when viewed from a top plan view. Further, features such as openings, slots, vias, holes, etc., can extend completely through the workpiece (e.g., so as to form so-called "through vias," "through holes," etc.) or only partially through the workpiece (e.g., so as to form so-called "blind vias," "blind holes," etc.).

Workpieces that may be processed can be generically characterized being formed of one or more metals, polymers, ceramics, composites, or any combination thereof (e.g., whether as an alloy, compound, mixture, solution, composite, etc.). Examples of workpieces that are specifically described herein include panels of printed circuit boards (PCBs) (also referred to herein as "PCB panels"), PCBs, flexible printed circuits (FPCs), integrated circuits (ICs), and IC packages (ICPs). However, it will be appreciated that other types of workpieces may also be beneficially processed, such as light-emitting diodes (LEDs), LED packages, semiconductor wafers, electronic or optical device substrates (e.g., substrates formed of $Al_2O_3$, AlN, BeO, Cu, GaAS, GaN, Ge, InP, Si, $SiO_2$, SiC, $Si_{1-x}Ge_x$, or the like, or any combination or alloy thereof), lead frames, lead frame blanks, articles formed of plastic, unstrengthened glass, thermally-strengthened glass, chemically-strengthened glass (e.g., via an ion-exchange process), quartz, sapphire, plastic, silicon, etc., components of electronic displays (e.g., substrates having formed thereon, TFTs, color filters, organic LED (OLED) arrays, quantum dot LED arrays, or the like or any combination thereof), lenses, mirrors, screen protectors, turbine blades, powders, films, foils, plates, molds (e.g., wax molds, molds for injection-molding processes, investment-casting processes, etc.), fabrics (woven, felted, etc.), surgical instruments, medical implants, consumer packaged goods, shoes, bicycles, automobiles, automotive or aerospace parts (e.g., frames, body panels, etc.), appliances (e.g., microwaves, ovens, refrigerators, etc.), device housings (e.g., for watches, computers, smartphones, tablet computers, wearable electronic devices, or the like or any combination thereof).

Accordingly, materials that may be processed include one or more metals such as Al, Ag, Au, Cu, Fe, In, Mg, Pt, Sn, Ti, or the like, or any combination thereof (e.g., whether as an alloy, composite, etc.), conductive metal oxides (e.g., ITO, etc.), transparent conductive polymers, ceramics, waxes, resins, inorganic dielectric materials (e.g., used as interlayer dielectric structures, such as silicon oxide, silicon nitride, silicon oxynitride, or the like or any combination thereof), low-k dielectric materials (e.g., methyl silsesquioxane (MSQ), hydrogen silsesquioxane (HSQ), fluorinated tetraethyl orthosilicate (FTEOS), or the like or any combination thereof), organic dielectric materials (e.g., SILK, benzocyclobutene, Nautilus, (all manufactured by Dow), polyfluorotetraethylene, (manufactured by DuPont), FLARE, (manufactured by Allied Chemical), or the like or any combination thereof), glass fibers, polymeric materials (polyamides, polyimides, polyesters, polyacetals, polycarbonates, modified polyphenylene ethers, polybutylene terephthalates, polyphenylene sulfides, polyether sulfones, polyether imides, polyether ether ketones, liquid crystal polymers, acrylonitrile butadiene styrene, and any compound, composite, or alloy thereof), leather, paper, build-up materials (e.g., ANJINOMOTO Build-up Film, also known as "ABF", etc.), glass-reinforced epoxy laminate (e.g., FR4), prepregs, solder resist, or the like or any composite, laminate, or other combination thereof.

## II. System - Overview

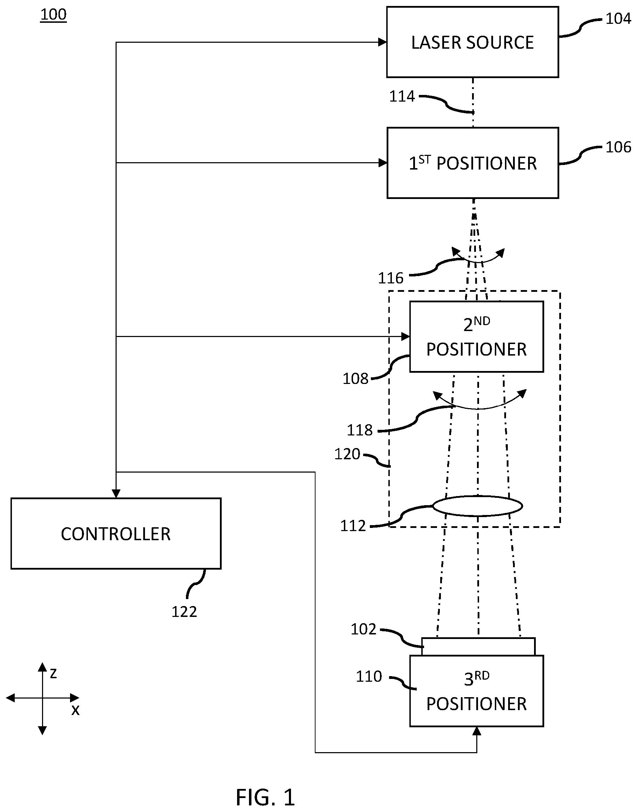

FIG. 1 schematically illustrates a laser-processing apparatus in accordance with one embodiment of the present invention.

Referring to the embodiment shown in FIG. 1, a laser-processing apparatus 100 (also referred to herein simply as an "apparatus") for processing a workpiece 102 can be characterized as including a laser source 104 for generating a beam of laser energy, a first positioner 106, a second positioner 108, a third positioner 110 and a scan lens 112. It should be noted that each of the second positioner 108, the third positioner 110 and scan lens 112 are optional, and may be omitted from the apparatus 100. The scan lens 112 and second positioner 108 can, optionally, be integrated into a common housing or "scan head" 120.

As discussed in greater detail below, the first positioner 106 is operative to diffract the beam of laser energy so as to deflect a beam path 114 to any of the second positioners 108. As used herein, the term "beam path" refers to the path along which laser energy in the beam of laser energy travels as it propagates from the laser source 104 to a scan lens 112. When deflecting the beam path 114 to the second positioner 108, the beam path 114 can be deflected by any angle (e.g., as measured relative to the beam path 114 incident upon the first positioner 106) within a first range of angles (also referred to herein as a "primary angular range 116").

The second positioner 108 is operative to diffract, reflect, refract, or the like, or any combination thereof, the beam of laser energy generated by the laser source 104 and deflected by the first positioner 106 (i.e., to "deflect" the beam of laser energy) so as to deflect the beam path 114 to scan lens 112. When deflecting the beam path 114 to the scan lens 112, the second positioner 108 can deflect the beam path 114 by any angle (e.g., as measured relative to the optical axis of the scan lens 112) within a second range of angles (also referred to herein as a "secondary angular range 118").

Laser energy deflected to a scan lens 112 is typically focused by the scan lens 112 and transmitted to propagate along a beam axis so as to be delivered to a workpiece 102. Laser energy delivered to a workpiece 102 may be characterized as having a Gaussian-type spatial intensity profile or a non-Gaussian-type (i.e., "shaped") spatial intensity profile (e.g., a "top-hat" spatial intensity profile, a super-Gaussian spatial intensity profile, etc.).

As used herein, the term "spot size" refers to the diameter or maximum spatial width of the beam of laser energy delivered at a location (also referred to as a "process spot," "spot location" or, more simply, a "spot") where the beam axis intersects a region of the workpiece 102 that is to be, at least partially, processed by the delivered beam of laser energy. For purposes of discussion herein, spot size is measured as a radial or transverse distance from the beam axis to where the optical intensity drops to, at least, $1/e^2$ of the optical intensity at the beam axis. Generally, the spot size of the beam of laser energy will be at a minimum at the beam waist. Once delivered to the workpiece 102, laser energy within the beam can be characterized as impinging the workpiece 102 at a spot size in a range from 2 $\mu$m to 200 $\mu$m. It will be appreciated, however, that the spot size can be made smaller than 2 $\mu$m or larger than 200 $\mu$m. Thus, the beam of laser energy delivered to the workpiece 102 can have a spot size greater than, less than, or equal to 2 $\mu$m, 3 $\mu$m, 5 $\mu$m, 7 $\mu$m, 10 $\mu$m, 15 $\mu$m, 30 $\mu$m, 35 $\mu$m, 40 $\mu$m, 45 $\mu$m, 50 $\mu$m, 55 $\mu$m, 80 $\mu$m, 100 $\mu$m, 150 $\mu$m, 200 $\mu$m, etc., or between any of these values.

The apparatus 100 may also include one or more other optical components (e.g., beam traps, beam expanders, beam shapers, beam splitters, apertures, filters, collimators, lenses, mirrors, prisms, polarizers, phase retarders, diffractive optical elements (commonly known in the art as DOEs), refractive optical elements (commonly known in the art as ROEs), or the like or any combination thereof) to focus, expand, collimate, shape, polarize, filter, split, combine, crop, absorb, or otherwise modify, condition, etc., the beam of laser energy as it propagates along beam path 114, to direct the beam of laser energy to the aforementioned first positioner 106, second positioner, etc., or the like or any combination thereof.

### A. Laser Source

In one embodiment, the laser source 104 is operative to generate laser pulses. As such, the laser source 104 may include a pulse laser source, a CW laser source, a QCW laser source, a burst mode laser, or the like or any combination thereof. In the event that the laser source 104 includes a QCW or CW laser source, the laser source 104 may be operated in a pulsed mode, or may be operated in a non-pulsed mode but further include a pulse gating unit (e.g., an acoustooptic (AO) modulator (AOM), a beam chopper, etc.) to temporally modulate beam of laser radiation output from the QCW or CW laser source. Although not illustrated, the apparatus 100 may optionally include one or more harmonic generation crystals (also known as "wavelength conversion crystals") configured to convert a wavelength of light output by the laser source 104. In another embodiment, however, the laser source 104 may be provided as a QCW laser source or a CW laser source and not include a pulse gating unit. Thus, the laser source 104 can be broadly characterized as operative to generate a beam of laser energy, which may manifested as a series of laser pulses or as a continuous or quasi-continuous laser beam, which can thereafter be propagated along the beam path 114. Although many embodiments discussed herein make reference to laser pulses, it should be recognized that continuous or quasi-continuous beams may alternatively, or additionally, be employed whenever appropriate or desired.

Laser energy output by the laser source 104 can have one or more wavelengths in the ultraviolet (UV), visible or infrared (IR) range of the electromagnetic spectrum. Laser energy in the UV range of the electromagnetic spectrum may have one or more wavelengths in a range from 10 nm (or thereabout) to 385 nm (or thereabout), such as 100 nm, 121 nm, 124 nm, 157 nm, 200 nm, 334 nm, 337 nm, 351 nm, 380 nm, etc., or between any of these values. Laser energy in the visible, green range of the electromagnetic spectrum may have one or more wavelengths in a range from 500 nm (or thereabout) to 560 nm (or thereabout), such as 511 nm, 515 nm, 530 nm, 532 nm, 543 nm, 568 nm, etc., or between any of these values. Laser energy in the IR range of the electromagnetic spectrum may have one or more wavelengths in a range from 750 nm (or thereabout) to 15 $\mu$m (or thereabout), such as 600 nm to 1000 nm, 752.5 nm, 780 nm to 1060 nm, 799.3 nm, 980 nm, 1047 nm, 1053 nm, 1060 nm, 1064 nm, 1080 nm, 1090 nm, 1152 nm, 1150 nm to 1350 nm, 1540 nm, 2.6 $\mu$m to 4 $\mu$m, 4.8 $\mu$m to 8.3 $\mu$m, 9.4 $\mu$m, 10.6 $\mu$m, etc., or between any of these values.

When the beam of laser energy is manifested as a series of laser pulses, the laser pulses output by the laser source 104 can have a pulse width or pulse duration (i.e., based on the full-width at half-maximum (FWHM) of the optical power in the pulse versus time) that is in a range from 10 fs to 900 ms. It will be appreciated, however, that the pulse duration can be made smaller than 10 fs or larger than 900 ms. Thus, at least one laser pulse output by the laser source 104 can have a pulse duration less than, greater than or equal to 10 fs, 15 fs, 30 fs, 50 fs, 100 fs, 150 fs, 200 fs, 300 fs, 500 fs, 600 fs, 750 fs, 800 fs, 850 fs, 900 fs, 950 fs, 1 ps, 2 ps, 3 ps, 4 ps, 5 ps, 7 ps, 10 ps, 15 ps, 25 ps, 50 ps, 75 ps, 100 ps. 200 ps, 500 ps, 1 ns, 1.5 ns, 2 ns, 5 ns, 10 ns, 20 ns, 50 ns, 100 ns, 200 ns, 400 ns, 800 ns, 1000 ns, 2 $\mu$s, 5 $\mu$s, 10 $\mu$s, 15 $\mu$s, 20 $\mu$s, 25 $\mu$s, 30 $\mu$s, 40 $\mu$s, 50 $\mu$s, 100 $\mu$s, 300 $\mu$s, 500 $\mu$s, 900 $\mu$s, 1 ms, 2 ms, 5 ms, 10 ms, 20 ms, 50 ms, 100 ms, 300 ms, 500 ms, 900 ms, 1 s, etc., or between any of these values.

Laser pulses output by the laser source 104 can have an average power in a range from 5 mW to 50 kW. It will be appreciated, however, that the average power can be made smaller than 5 mW or larger than 50 kW. Thus, laser pulses output by the laser source 104 can have an average power less than, greater than or equal to 5 mW, 10 mW, 15 mW, 20 mW, 25 mW, 50 mW, 75 mW, 100 mW, 300 mW, 500 mW, 800 mW, 1 W, 2 W, 3 W, 4 W, 5 W, 6 W, 7 W, 10 W, 15 W, 18 W, 25 W, 30 W, 50 W, 60 W, 100 W, 150 W, 200 W, 250 W, 500 W, 2 kW, 3 kW, 20 kW, 50 kW, etc., or between any of these values.

Laser pulses can be output by the laser source 104 at a pulse repetition rate in a range from 5 kHz to 5 GHz. It will be appreciated, however, that the pulse repetition rate can be less than 5 kHz or larger than 5 GHz. Thus, laser pulses can be output by the laser source 104 at a pulse repetition rate less than, greater than or equal to 5 kHz, 50 kHz, 100 kHz, 175 kHz, 225 kHz, 250 kHz, 275 kHz, 500 kHz, 800 kHz, 900 kHz, 1 MHz, 1.5 MHz, 1.8 MHz, 1.9 MHz, 2 MHz, 2.5 MHz, 3 MHz, 4 MHz, 5 MHz, 10 MHz, 20 MHz, 50 MHz, 60 MHz, 100 MHz, 150 MHz, 200 MHz, 250 MHz, 300 MHz, 350 MHz, 500 MHz, 550 MHz, 600 MHz, 900 MHz, 2 GHz, 10 GHz, etc., or between any of these values.

In addition to wavelength, average power and, when the beam of laser energy is manifested as a series of laser pulses, pulse duration and pulse repetition rate, the beam of laser energy delivered to the workpiece 102 can be characterized by one or more other characteristics such as pulse energy, peak power, etc., which can be selected (e.g., optionally based on one or more other characteristics such as wavelength, pulse duration, average power and pulse repetition rate, spot size, etc.) to irradiate the workpiece 102 at the process spot to process the workpiece 102 (e.g., to form one or more features).

Examples of types of lasers that the laser source 104 may be characterized as gas lasers (e.g., carbon dioxide lasers, carbon monoxide lasers, excimer lasers, etc.), solid-state lasers (e.g., Nd:YAG lasers, etc.), rod lasers, fiber lasers, photonic crystal rod/fiber lasers, passively mode-locked solid-state bulk or fiber lasers, dye lasers, mode-locked diode lasers, pulsed lasers (e.g., ms-, ns-, ps-, fs-pulsed lasers), CW lasers, QCW lasers, or the like or any combination thereof. Depending upon their configuration, gas lasers (e.g., carbon dioxide lasers, etc.) may be configured to operate in one or more modes (e.g., in CW mode, QCW mode, pulsed mode, or any combination thereof). Specific examples of laser sources that may be provided as the laser source 104 include one or more laser sources such as: the BOREAS, HEGOA, SIROCCO or CHINOOK series of lasers manufactured by EOLITE; the PYROFLEX series of lasers manufactured by PYROPHOTONICS; the PALADIN Advanced 355, DIAMOND series (e.g., DIAMOND E, G, J-2, J-3, J-5 series), the FLARE NX, MATRIX QS DPSS, MEPHISTO Q, AVIA LX, AVIA NX, RAPID NX, HYPERRAPID NX, RAPID, HELIOS, FIDELITY, MONACO, OPERA, or RAPID FX series of lasers manufactured by COHERENT; the ASCEND, EXCELSIOR, EXPLORER, FEMTOTRAIN, HIGHQ-2, HIPPO, ICEFYRE, NAVIGATOR, QUANTA-RAY, QUASAR, SOLSTICS ACE, SPIRIT, TALON, VANGUARD or VGEN series of lasers manufactured by SPECTRA PHYSICS; the PULSTAR- or FIRESTAR-series lasers manufactured by SYNRAD; the TRUFLOW-series of lasers (e.g., TRUFLOW 2000, 2600, 3000, 3200, 3600, 4000, 5000, 6000, 6000, 8000, 10000, 12000, 15000, 20000), TRUCOAX series of lasers (e.g., TRUCOAX 1000) or the TRUDISK, TRUPULSE, TRUDIODE, TRUFIBER, or TRUMICRO series of lasers, all manufactured by TRUMPF; the FCPA μJEWEL or FEMTOLITE series of lasers manufactured by IMRA AMERICA; the TANGERINE and SATSUMA series lasers (and MIKAN and T-PULSE series oscillators) manufactured by AMPLITUDE SYSTEMES; CL, CLPF, CLPN, CLPNT, CLT, ELM, ELPF, ELPN, ELPP, ELR, ELS, FLPN, FLPNT, FLT, GLPF, GLPN, GLR, HLPN, HLPP, RFL, TLM, TLPN, TLR, ULPN, ULR, ULM, VLM, VLPN, YLM, YLPF, YLPN, YLPP, YLR, YLS, FLPM, FLPMT, DLM, BLM, or DLR series of lasers manufactured by IPG PHOTONICS (e.g., including the GPLN-532-100, GPLN-532-200, GPLN-532-500, ULR/ULM-355-200, etc.), or the like or any combination thereof.

## B. First Positioner

Generally, the first positioner 106 is operative to impart movement of the beam axis relative to the workpiece 102 along the X-axis (or direction), a Y-axis (or direction), or a combination thereof (e.g., by deflecting of the beam path 114 within the first primary angular range 116). Although not illustrated, the Y-axis (or Y-direction) will be understood to refer to an axis (or direction) that is orthogonal to the illustrated X- and Z-axes (or directions).

Movement of the beam axis relative to the workpiece 102, as imparted by the first positioner 106, is generally limited such that the process spot can be scanned, moved or otherwise positioned within a first scan field projected by a scan lens 112. Generally, and depending upon one or more factors such as the configuration of the first positioner 106, the location of the first positioner 106 along the beam path 114, the beam size of the beam of laser energy incident upon the first positioner 106, the spot size, etc., the first scan field may extend, in any of the X- or Y-directions, to a distance that is less than, greater than or equal to 0.01 mm, 0.04 mm, 0.1 mm, 0.5 mm, 1.0 mm, 1.4 mm, 1.5 mm, 1.8 mm, 2 mm, 2.5 mm, 3.0 mm, 3.5 mm, 4.0 mm, 4.2 mm, 5 mm, 10 mm, 25 mm, 50 mm. 60 mm, etc., or between any of these values. As used herein, the term "beam size" refers to the diameter or width of the beam of laser energy, and can be measured as a radial or transverse distance from the beam axis to where the optical intensity drops to $1/e^2$ of the optical intensity at the axis of propagation along the beam path 114. A maximum dimension of the first scan field (e.g., in a plane containing the X- and Y-axes, herein referred to as the "X-Y plane") may be greater than, equal to or less than a maximum dimension (as measured in the X-Y plane) of a feature (e.g., an opening, a recess, a via, a trench, etc.) to be formed in the workpiece 102.

Generally, the first positioner 106 is provided as an AO deflector (AOD) system, which includes one or more AODs having an AO cell formed of a material such as crystalline germanium (Ge), gallium arsenide (GaAs), wulfenite ($PbMoO_4$), tellurium dioxide ($TeO_2$), crystalline quartz, glassy $SiO_2$, arsenic trisulfide ($As_2S_3$), lithium niobate ($LiNbO_3$), or the like or any combination thereof. In one embodiment, the AOD system includes at least one (e.g., one, two, three, four, five, six, etc.) single-element AOD, at least one (e.g., one, two, three, four, five, six, etc.) multi-element AOD, or the like or any combination thereof. An AOD system including only one AOD is herein referred to as a "single-cell AOD system," and an AOD system including more than one AOD is herein referred to as a "multi-cell AOD system." As used herein, a "single-element" AOD refers to an AOD having only one ultrasonic transducer element acoustically coupled to the AO cell, whereas a "multi-element" AOD includes at least two ultrasonic transducer elements acoustically coupled to a common AO cell. The AOD system may be provided as single-axis AOD system (e.g., operative to deflect the beam axis along a single axis) or as a multi-axis AOD system (e.g., operative to deflect the beam axis along one or more axes, such as along the X-axis, along the Y- axis, or any combination thereof) by deflecting the beam path 114 in a corresponding manner. Generally, a multi-axis AOD system can be provided as a single- or multi-cell AOD system. A multi-cell, multi-axis AOD system typically includes multiple AODs, each operative to deflect the beam axis along a different axis. For example, a multi-cell, multi-axis system can include a first AOD (e.g., a single- or multi-element AOD system) operative to deflect the beam axis along one axis (e.g., along the X- axis), and a second AOD (e.g., a single- or multi-element AOD) operative to deflect the beam axis along a second axis (e.g., along the Y-axis). A single-cell, multi-axis system typically includes a single AOD operative to deflect the beam axis along two axes (e.g., along the X- and Y-axes). For example, a single-cell, multi-axis system can include at least two ultrasonic transducer elements acoustically coupled to orthogonally-arranged planes, facets, sides, etc., of a common AO cell.

As will be recognized by those of ordinary skill, AO technologies (e.g., AODs, AOMs, etc.) utilize diffraction effects caused by one or more acoustic waves propagating through the AO cell (i.e., along a "diffraction axis" of the AOD) to diffract an incident optical wave (i.e., a beam of laser energy, in the context of the present application) contemporaneously propagating through the AO cell (i.e., along an "optical axis" within the AOD). Diffracting the incident beam of laser energy produces a diffraction pattern that typically includes zeroth- and first-order diffraction peaks, and may also include other higher-order diffraction peaks (e.g., second-order, third-order, etc.). As is known in the art, the portion of the diffracted beam of laser energy in the zeroth-order diffraction peak is referred to as a "zeroth-order" beam, the portion of the diffracted beam of laser energy in the first-order diffraction peak is referred to as a "first-order" beam, and so on. Generally, the zeroth-order beam and other diffracted-order beams (e.g., the first-order beam, etc.) propagate along different beam paths upon exiting the AO cell (e.g., through an optical output side of the AO cell). For example, the zeroth-order beam propagates along a zeroth-order beam path, the first-order beam propagates along a first-order beam path, and so on.

Acoustic waves are typically launched into the AO cell by applying an RF drive signal (e.g., from one or more drivers of the first positioner 106) to the ultrasonic transducer element. Characteristics of the RF drive signal (e.g., amplitude, frequency, phase, etc.) can be controlled (e.g., based on one or more control signals output by the controller 122, a component-specific controller, or the like or any combination thereof) to adjust the manner with which the incident optical wave is diffracted. For example, the frequency of the applied RF drive signal will determine the angle to which the beam path 114 is deflected. As is known in the art, the angle, $\Theta$, by which the beam path 114 is deflected is can be calculated as follows:

$$\theta = \frac{\lambda \cdot f}{v}$$

where $\lambda$ is the optical wavelength (measured in nm) of the beam of laser energy, $f$ is the frequency (measured in Hz) of the applied RF drive signal, and $v$ is the velocity (measured in m/s) of the acoustic wave in the AO cell. If the frequency of the applied RF drive signal is composed of multiple frequencies, then the beam path 114 will be deflected simultaneously by multiple angles.

The first-order beam path exiting the AO cell can typically be regarded as the beam path 114 that has been rotated or deflected within the AO cell. Unless otherwise expressly stated herein, the beam path 114 exiting the AO cell corresponds to the first-order beam path. The axis (also referred to herein as the "rotation axis") about which the beam path 114 exiting the AO cell is rotated (e.g., relative to the beam path 114 as it is incident upon the AO cell) is orthogonal to both the diffraction axis of the AO cell and the optical axis along which the incident beam of laser energy propagates within the AO cell when the AOD is operated or driven to diffract the incident beam of laser energy. The AOD thus deflects an incident beam path 114 within a plane (also referred to herein as a "plane of deflection") that contains (or is otherwise generally parallel to) the diffraction axis of the AO cell and the optical axis within the AO cell. The spatial extent across which an AOD can deflect the beam path 114 within the plane of deflection is herein referred to as the "scan field" of that AOD. Accordingly, the first scan field of the first positioner 106 can be considered to correspond to the scan field of a single AOD (e.g., in the event the first positioner 106 includes a single AOD) or to correspond to combined scan fields of multiple AODs (e.g., in the event the first positioner 106 includes multiple AODs).

The first positioner 106 can be characterized as having a "first positioning rate," which refers to the rate with which the first positioner 106 positions the process spot at any location within the first scan field (thus moving the beam axis). For example, the first positioning rate can be greater than, equal to or less than 8 kHz, 10 kHz, 20 kHz, 30 kHz, 40 kHz, 50 kHz, 75 kHz, 80 kHz, 100 kHz, 250 kHz, 500 kHz, 750 kHz, 1 MHz, 5 MHz, 10 MHz, 20 MHz, 40 MHz, 50 MHz, 75 MHz, 100 MHz, 125 MHz, 150 MHz, 175 MHz, 200 MHz, 225 MHz, 250 MHz, etc., or between any of these values. This range is also referred to herein as the first positioning bandwidth. During operation of the first positioner 106, RF drive signals are repeatedly applied to one or more ultrasonic transducers of the first positioner 106, and the first positioning bandwidth corresponds (e.g., is equal to, or at least substantially equal to) the rate with which the RF drive signals are applied. The rate with which the RF drive signals are applied is also referred to as the "update rate" or "refresh rate." The inverse of the first positioning rate is herein referred to as the "first positioning period." and thus refers to the minimum amount of time that elapses before the position of the process spot is changed from one location within the first scan field to another location within the first scan field. Thus, the first positioner 106 can be characterized as having a first positioning period that is greater than, equal to or less than 200 μs, 125 μs, 100 μs, 50 μs, 33 μs, 25 μs, 20 μs, 15 μs, 13.3 μs, 12.5 μs, 10 μs, 4 μs, 2 μs, 1.3 μs, 1 μs, 0.2 μs, 0.1 μs, 0.05 μs, 0.025 μs, 0.02 μs, 0.013 μs, 0.01 μs, 0.008 μs, 0.0067 μs, 0.0057 μs, 0.0044 μs, 0.004 μs, etc., or between any of these values.

It will be appreciated that the material from which the AO cell is formed will depend upon the wavelength of the laser energy that propagates along the beam path 114 so as to be incident upon the AO cell. For example, a material such as crystalline germanium can be used where the wavelength of laser energy to be deflected is in a range from 2 μm (or thereabout) to 20 μm (or thereabout), materials such as gallium arsenide and arsenic trisulfide can be used where the wavelength of the beam of laser energy to be deflected is in a range from 1 μm (or thereabout) to 11 μm (or thereabout), and materials such as glassy $SiO_2$, quartz, lithium niobate, wulfenite, and tellurium dioxide can be used where the wavelength of laser energy to be deflected is in a range from 200 nm (or thereabout) to 5 μm (or thereabout).

When the beam of laser energy output by the laser source 104 is manifested as a series of laser pulses, the first positioner 106 can be operated to deflect the beam path 114 by different angles within the primary angular range 116. In one embodiment, the first positioning period is greater than or equal to the pulse duration of each of the laser pulses. Accordingly, a laser pulse can transit through the AO cell of an AOD while the AOD is driven at a fixed RF drive frequency (or a fixed set of RF drive frequencies). Maintaining a fixed RF drive frequency (or a fixed set of RF drive frequencies) applied to an AOD while a laser pulse is transiting through the AO cell of the AOD generally results in uniformly deflecting the laser pulse for the entire pulse duration of the laser pulse and, so, can also be referred to as "whole-pulse deflection." In another embodiment, however, the first positioning period can be less than the pulse duration of a laser pulse; so the laser pulse can transit through the AO cell of the AOD while the RF drive frequency (or the frequencies within the set of RF drive frequencies) is varied. Varying an RF drive frequency applied to an AOD while a laser pulse is transiting through the AO cell of the AOD can result in temporally-dividing the laser pulse and, so, can also be referred to as "partial-pulse deflection" or "pulse slicing." Certain aspects of pulse slicing will be described in greater detail below. Although pulse slicing techniques are described herein as being applied to temporally-divide a laser pulse, it will be appreciated that these techniques can likewise be applied to temporally-divide a beam of laser energy manifested as a continuous or quasi-continuous laser beam.

## C. Second Positioner

Generally, the second positioner 108 is operative to impart movement of the beam axis relative to the workpiece 102 along the X-axis (or direction), the Y-axis (or direction), or a combination thereof (e.g., by deflecting the beam path 114 within the first secondary angular range 118a or within the second secondary angular range 118b).

Movement of the beam axis relative to the workpiece 102, as imparted by the second positioner 108, is generally limited such that the process spot can be scanned, moved or otherwise positioned within a second scan field projected by a scan lens 112. Generally, and depending upon one or more factors such as the configuration of the second positioner 108, the location of the second positioner 108 along the beam path 114, the beam size of the beam of laser energy incident upon the second positioner 108, the spot size, etc., the second scan field may extend, in any of the X- or Y-directions to a distance that is greater than a corresponding distance of the first scan field. In view of the above, the second scan field may extend, in any of the X- or Y-directions, to a distance that is less than, greater than or equal to 1 mm, 25 mm, 50 mm, 75 mm, 100 mm, 250 mm, 500 mm, 750 mm, 1 cm, 25 cm, 50 cm, 75 cm, 1 m, 1.25 m, 1.5 m, etc., or between any of these values. A maximum dimension of the second scan field (e.g., in the X-Y plane) may be greater than, equal to or less than a maximum dimension (as measured in the X-Y plane) of a feature (e.g., an opening, a recess, a via, a trench, a scribe line, a conductive trace, etc.) to be formed in the workpiece 102.

In view of the configuration described herein, it should be recognized that movement of the beam axis imparted by the first positioner 106 can be superimposed by movement of the beam axis imparted by the second positioner 108. Thus, the second positioner 108 is operative to scan the first scan field within the second scan field.

Generally, the positioning rate with which the second positioner 108 is capable of positioning the process spot at any location within the second scan field (thus moving the beam axis within the second scan field and/or scanning the first scan field within the second scan field) spans a range (also referred to herein as the "second positioning bandwidth") that is less than the first positioning bandwidth. In one embodiment, the second positioning bandwidth is in a range from 500 Hz (or thereabout) to 8 kHz (or thereabout). For example, the second positioning bandwidth can be greater than, equal to or less than 500 Hz, 750 Hz, 1 kHz, 1.25 kHz, 1.5 kHz, 1.75 kHz, 2 kHz, 2.5 kHz, 3 kHz, 3.5 kHz, 4 kHz, 4.5 kHz, 5 kHz, 5.5 kHz, 6 kHz, 6.5 kHz, 7 kHz, 7.5 kHz, 8 kHz, etc., or between any of these values.

In one embodiment, the second positioner 108 can be provided as a galvanometer mirror system including two galvanometer mirror components, i.e., a first galvanometer mirror component (e.g., an X-axis galvanometer mirror component) arranged to impart movement of the beam axis relative to the workpiece 102 along the X-axis and a second galvanometer mirror component (e.g., a Y-axis galvanometer mirror component) arranged to impart movement of the beam axis relative to the workpiece 102 along the Y- axis. In another embodiment, however, the second positioner 108 may be provided as a galvanometer mirror system including only a single galvanometer mirror component arranged to impart movement of the beam axis relative to the workpiece 102 along the X- and Y- axes. In yet other embodiments, the second positioner 108 may be provided as a rotating polygon mirror system, etc. It will thus be appreciated that, depending on the specific configuration of the second positioner 108 and the first positioner 106, the second positioning bandwidth may be greater than or equal to the first positioning bandwidth.

### D. Third Positioner

The third positioner 110 is operative to impart movement of a workpiece 102 (e.g., workpieces 102a and 102b) relative to the scan lens 112, and, consequently, impart movement of the workpiece 102 relative to the beam axis. Movement of a workpiece 102 relative to the beam axis is generally limited such that the process spot can be scanned, moved or otherwise positioned within a third scan field. Depending upon one or more factors such as the configuration of the third positioner 110, the third scan field may extend, in the X-direction, the Y-direction, or any combination thereof, to a distance that is greater than or equal to a corresponding distance of the second scan field. Generally, however, a maximum dimension of the third scan field (e.g., in the X-Y plane) will be greater than or equal to a corresponding maximum dimension (as measured in the X-Y plane) of any feature to be formed in the workpiece 102. Optionally, the third positioner 110 may be operative to move the workpiece 102 relative to the beam axis within a scan field that extends in the Z-direction (e.g., over a range between 1 mm and 50 mm). Thus, the third scan field may extend along the X-, Y- and/or Z-directions.

In view of the configuration described herein, it should be recognized that movement of the process spot relative to the workpiece 102 (e.g., as imparted by the first positioner 106 and/or the second positioner 108) can be superimposed by movement of the workpiece 102 as imparted by the third positioner 110. Thus, the third positioner 110 is operative to scan the first scan field and/or second scan field within the third scan field. Generally, the positioning rate with which the third positioner 110 is capable of positioning the workpiece 102 at any location within the third scan field (thus moving the workpiece 102, scanning the first scan field within the third scan field, and/or scanning the second scan field within the third scan field) spans a range (also referred to herein as the "third positioning bandwidth") that is less than the second positioning bandwidth. In one embodiment, the third positioning bandwidth is less than 500 Hz (or thereabout). For example, the third positioning bandwidth can be equal to or less than 500 Hz, 250 Hz, 150 Hz, 100 Hz, 75 Hz, 50 Hz, 25 Hz, 10 Hz, 7.5 Hz, 5 Hz, 2.5 Hz, 2 Hz, 1.5 Hz, 1 Hz, etc., or between any of these values.

In one embodiment, the third positioner 110 is provided as one or more linear stages (e.g., each capable of imparting translational movement to the workpiece 102 along the X-, Y- and/or Z-directions), one or more rotational stages (e.g., each capable of imparting rotational movement to the workpiece 102 about an axis parallel to the X-, Y- and/or Z-directions), or the like or any combination thereof. In one embodiment, the third positioner 110 includes an X-stage for moving the workpiece 102 along the X-direction, and a Y-stage supported by the X-stage (and, thus, moveable along the X-direction by the X-stage) for moving the workpiece 102 along the Y-direction.

As described thus far, the apparatus 100 could employ a so-called "stacked" positioning system as the third positioner 110, which enables the workpiece 102 to be moved while positions of other components such as the first positioner 106, second positioner 108, scan lens 112, etc., are kept stationary within the apparatus 100 (e.g., via one or more supports, frames, etc., as is known in the art) relative to the workpiece 102. In another embodiment, the third positioner 110 may be arranged and operative to move one or more components such as the first positioner 106, second positioner 108, scan lens 112, or the like or any combination thereof, and the workpiece 102 may be kept stationary.

In yet another embodiment, the third positioner 110 can be provided as a so-called "split-axis" positioning system in which one or more components such as the first positioner 106, second positioner 108, scan lens 112, or the like or any combination thereof, are carried by one or more linear or rotational stages (e.g., mounted on a frame, gantry, etc.) and the workpiece 102 is carried by one or more other linear or rotational stages. In such an embodiment, the third positioner 110 includes one or more linear or rotational stages arranged and operative to move one or more components such as the scan head (e.g., including the second positioner 108 and scan lens 112) and one or more linear or rotational stages arranged and operative to move the workpiece 102. For example, the third positioner 110 may include a Y-stage for imparting movement of the workpiece 102 along the Y-direction and an X-stage for imparting movement of the scan head along the X-direction. Some examples of split-axis positioning systems that may be beneficially or advantageously employed in the apparatus 100 include any of those disclosed in U.S. Patent Nos. 5,751,585, 5,798,927, 5,847,960, 6,606,999, 7,605,343, 8,680,430, 8,847,113, or in U.S. Patent App. Pub. No. 2014/0083983, or any combination thereof.

In one embodiment in which the third positioner 110 includes a Z-stage, the Z-stage may be arranged and configured to move the workpiece 102 along the Z-direction. In this case, the Z-stage may be carried by one or more of the other aforementioned stages for moving or positioning the workpiece 102, may carry one or more of the other aforementioned stages for moving or positioning the workpiece 102, or any combination thereof. In another embodiment in which the third positioner 110 includes a Z-stage, the Z-stage may be arranged and configured to move the scan head along the Z-direction. Thus, in the case where the third positioner 110 is provided as a split-stage positioning system, the Z-stage may carry, or be carried by, the X-stage. Moving the workpiece 102 or the scan head along the Z-direction can result in a change in spot size at the workpiece 102.

In still another embodiment, one or more components such as the first positioner 106, second positioner 108, scan lens 112, etc., may be carried by an articulated, multi-axis robotic arm (e.g., a 2-, 3-, 4-, 5-, or 6-axis arm). In such an embodiment, the second positioner 108 and/or scan lens 112 may, optionally, be carried by an end effector of the robotic arm. In yet another embodiment, the workpiece 102 may be carried directly on an end effector of an articulated, multi-axis robotic arm (i.e., without the third positioner 110). In still another embodiment, the third positioner 110 may be carried on an end effector of an articulated, multi-axis robotic arm.

### D. Scan Lens

The scan lens 112 (e.g., provided as either a simple lens, or a compound lens) is generally configured to focus the beam of laser energy directed along the beam path, typically so as to produce a beam waist that can be positioned at or near the desired process spot. The scan lens 112 may be provided as an non-telecentric f-theta lens (as shown), a telecentric f-theta lens, an axicon lens (in which case, a series of beam waists are produced, yielding a plurality of process spots displaced from one another along the beam axis), or the like or any combination thereof.

In one embodiment, the scan lens 112 is provided as a fixed-focal length lens and is coupled to a scan lens positioner (e.g., a lens actuator, not shown) operative to move the scan lens 112 (e.g., so as to change the position of the beam waist along the beam axis). For example, the lens actuator may be provided as a voice coil operative to linearly translate the scan lens 112 along the Z-direction. In this case, the scan lens 112 may be formed of a material such as fused silica, optical glass, zinc selenide, zinc sulfide, germanium, gallium arsenide, magnesium fluoride, etc. In another embodiment, the scan lens 112 is provided as a variable-focal length lens (e.g., a zoom lens, or a so-called "liquid lens" incorporating technologies currently offered by COGNEX, VARIOPTIC, etc.) capable of being actuated (e.g., via a lens actuator) to change the position of the beam waist along the beam axis. Changing the position of the beam waist along the beam axis can result in a change in spot size at the workpiece 102.

In an embodiment in which the apparatus 100 includes a lens actuator, the lens actuator may be coupled to the scan lens 112 (e.g., so as to enable movement of the scan lens 112 within the scan head, relative to the second positioner 108). Alternatively, the lens actuator may be coupled to the scan head 120 (e.g., so as to enable movement of the scan head itself, in which case the scan lens 112 and the second positioner 108 would move together). In another embodiment, the scan lens 112 and the second positioner 108 are integrated into different housings (e.g., such that the housing in which the scan lens 112 is integrated is movable relative to the housing in which the second positioner 108 is integrated).

### F. Controller

Generally, the apparatus 100 includes one or more controllers, such as controller 122, to control, or facilitate control of, the operation of the apparatus 100. In one embodiment, the controller 122 is communicatively coupled (e.g., over one or more wired or wireless, serial or parallel, communications links, such as USB, RS-232, Ethernet, Firewire, Wi-Fi, RFID, NFC, Bluetooth, Li-Fi, SERCOS, MARCO, EtherCAT, or the like or any combination thereof) to one or more components of the apparatus 100, such as the laser source 104, the first positioner 106, the second positioner 108, third positioner 110, the lens actuator, the scan lens 112 (when provided as a variable-focal length lens), etc., which are thus operative in response to one or more control signals output by the controller 122.

For example, the controller 122 may control an operation of the first positioner 106, the second positioners 108, or the third positioner 110, or any combination thereof, to impart relative movement between the beam axis and the workpiece so as to cause relative movement between the process spot and the workpiece 102 along a path or trajectory (also referred to herein as a "process trajectory") within the workpiece 102. It will be appreciated that any two of these positioners, or all three of these positioners, may be controlled such that two positioners (e.g., the first positioner 106 and the second positioner 108, the first positioner 106 and the third positioner 110, or the second positioner 108 and the third positioner 110), or all three positioners simultaneously impart relative movement between the process spot and the workpiece 102 (thereby imparting a "compound relative movement" between the beam axis and the workpiece). Of course, at any time, it is possible to control only one positioner (e.g., the first positioner 106, the second positioner 108 or the third positioner 110) to impart relative movement between the process spot and the workpiece 102 (thereby imparting a "non-compound relative movement" between the beam axis and the workpiece).

In one embodiment, the controller 122 may control an operation of the first positioner 106 to deflect the beam path 114 within the primary angular range 116 in a manner that imparts compound relative movement (e.g., in coordination with the second positioner 108, in coordination with the third positioner 110, or any combination thereof) or non-compound relative movement between the beam axis and each workpiece 102 so as to cause relative movement between the process spot and the workpiece 102 along a process trajectory within the workpiece 102. In another embodiment, the controller 122 may control an operation of the first positioner 106 to deflect the beam path 114 within each primary angular range 116 in a manner that compensates for tracking errors introduced by the second positioner 108.

Some other examples of operations that one or more of the aforementioned components can be controlled to perform include any operations, functions, processes, and methods, etc., as disclosed in aforementioned U.S. Patent Nos. 5,751,585, 5,847,960, 6,606,999, 8,680,430, 8,847,113, or as disclosed in U.S. Patent Nos. 4,912,487, 5,633,747, 5,638,267, 5,917,300, 6,314,463, 6,430,465, 6,600,600, 6,606,998, 6,816,294, 6,947,454, 7,019,891, 7,027,199, 7,133,182, 7,133,186, 7,133,187, 7,133,188, 7,244,906, 7,245,412, 7,259,354, 7,611,745, 7,834,293, 8,026,158, 8,076,605, 8,288,679, 8,404,998, 8,497,450, 8,648,277, 8,896,909, 8,928,853, 9,259,802, or in U.S. Patent App. Pub. Nos. 2014/0026351, 2014/0196140, 2014/0263201, 2014/0263212, 2014/0263223, 2014/0312013, or in German Patent No. DE102013201968B4, or in International Patent Pub. No. WO2009/087392, or any combination thereof. In another example, the controller 122 may control an operation of any positioner that includes one or more AODs (e.g., in some embodiments, the first positioner 106, the second positioner 108, or a combination thereof) to change the spot shape or spot size of the beam of laser energy delivered to the process spot (e.g., by chirping an RF signal applied to one or more ultrasonic transducer elements of the one or more AODs, by applying a spectrally-shaped RF signal to one or more ultrasonic transducer elements of the one or more AODs, or the like or any combination thereof) as, for example, disclosed in International Patent Pub. No. WO2017/044646 A1. The applied RF signal may be chirped linearly, or nonlinearly, in any desired or suitable manner. For example, the applied RF signal may be chirped at a first rate and then at a second rate to diffract a beam of laser energy transiting the AO cell in two different manners. In this case, the first rate may be slower than or faster than the second rate.

Generally, the controller 122 includes one or more processors operative to generate the aforementioned control signals upon executing instructions. A processor can be provided as a programmable processor (e.g., including one or more general purpose computer processors, microprocessors, digital signal processors, or the like or any combination thereof) operative to execute the instructions. Instructions executable by the processor(s) may be implemented software, firmware, etc., or in any suitable form of circuitry including programmable logic devices (PLDs), field-programmable gate arrays (FPGAs), field-programmable object arrays (FPOAs), application-specific integrated circuits (ASICs) - including digital, analog and mixed analog/digital circuitry - or the like, or any combination thereof. Execution of instructions can be performed on one processor, distributed among processors, made parallel across processors within a device or across a network of devices, or the like or any combination thereof.

The controller 122 includes tangible media such as computer memory, which is accessible (e.g., via one or more wired or wireless communications links) by the processor. As used herein, "computer memory" includes magnetic media (e.g., magnetic tape, hard disk drive, etc.), optical discs, volatile or non-volatile semiconductor memory (e.g., RAM, ROM, NAND-type flash memory, NOR-type flash memory, SONOS memory, etc.), etc., and may be accessed locally, remotely (e.g., across a network), or a combination thereof. Generally, the instructions may be stored as computer software (e.g., executable code, files, instructions, etc., library files, etc.), which can be readily authored by artisans, from the descriptions provided herein, e.g., written in C, C++, Visual Basic, Java, Python, Tel, Perl, Scheme, Ruby, assembly language, hardware description language (e.g., VHDL, VERILOG, etc.), etc. Computer software is commonly stored in one or more data structures conveyed by computer memory.

Although not shown, one or more drivers (e.g., RF drivers, servo drivers, line drivers, power sources, etc.) can be communicatively coupled to an input of one or more components such as the laser source 104, the first positioner 106, the second positioner 108, the third positioner 110, the lens actuator, the scan lens 112 (when provided as a variable-focal length lens), etc., for controlling such components. Accordingly, one or more components such as the laser source 104, the first positioner 106, the second positioner 108, the third positioner 110, the lens actuator, the scan lens 112 (when provided as a variable-focal length lens), etc., can be considered to also include any suitable driver, as is known in the art. Each of such drivers would typically include an input communicatively coupled to the controller 122 and the controller 122 is operative to generate one or more control signals (e.g., trigger signals, etc.), which can be transmitted to the input(s) of one or more drivers associated with one or more components of the apparatus 100. Components such as the laser source 104, first positioner 106, second positioner 108, third positioner 110, lens actuator, the scan lens 112 (when provided as a variable-focal length lens), etc., are thus responsive to control signals generated by the controller 122.

Although not shown, one or more additional controllers (e.g., component-specific controllers) may, optionally, be communicatively coupled to an input of a driver communicatively coupled to a component (and thus associated with the component) such as the laser source 104, the first positioner 106, the second positioner 108, the third positioner 110, the lens actuator, the scan lens 112 (when provided as a variable-focal length lens), etc. In this embodiment, each component-specific controller can be communicatively coupled to the controller 122 and be operative to generate, in response to one or more control signals received from the controller 122, one or more control signals (e.g., trigger signals, etc.), which can then be transmitted to the input(s) of the driver(s) to which it is communicatively coupled. In this embodiment, a component-specific controller may be operative as similarly described with respect to the controller 122.

In another embodiment in which one or more component-specific controllers are provided, the component-specific controller associated with one component (e.g., the laser source 104) can be communicatively coupled to the component-specific controller associated with one component (e.g., the first positioner 106, etc.). In this embodiment, one or more of the component-specific controllers can be operative to generate one or more control signals (e.g., trigger signals, etc.) in response to one or more control signals received from one or more other component-specific controllers.

### III. Additional Discussion Concerning Multi-Axis AOD Systems

In numerous embodiments discussed herein, the first positioner 106 is provided as a multi-axis AOD system. Depending upon the construction of the AOD within the AOD system, the AOD can be characterized as a longitudinal-mode AOD or as a shear-mode AOD, and be operative to diffract a beam of laser energy that is linearly polarized or circularly polarized. Thus depending upon the wavelength of the beam of laser energy and upon the material from which the AO cell of the AOD in the AOD system is formed, the AOD can be oriented such that the diffraction axis of the AO cell in the AOD is parallel or perpendicular to (or at least substantially parallel or perpendicular to) the plane of polarization of the beam of laser energy that is incident thereto. For example, if the wavelength of the beam of laser energy is in the ultraviolet or visible green ranges of the electromagnetic spectrum and the AO cell of an AOD is formed of a material such as quartz, then the AOD can be oriented such that the diffraction axis of the AO cell is perpendicular to (or at least substantially perpendicular to) the plane of polarization of the beam of laser energy that is incident thereto. In another example, if the wavelength of the beam of laser energy is in the so-called mid- or long-wavelength infrared ranges of the electromagnetic spectrum (i.e., wavelengths spanning a range from 3 $\mu$m (or thereabout) to 15 $\mu$m (or thereabout)) and the AO cell of an AOD is formed of a material such as crystalline germanium, then the AOD can be oriented such that the diffraction axis of the AO cell is parallel to (or at least substantially parallel to) the plane of polarization of the beam of laser energy that is incident thereto.

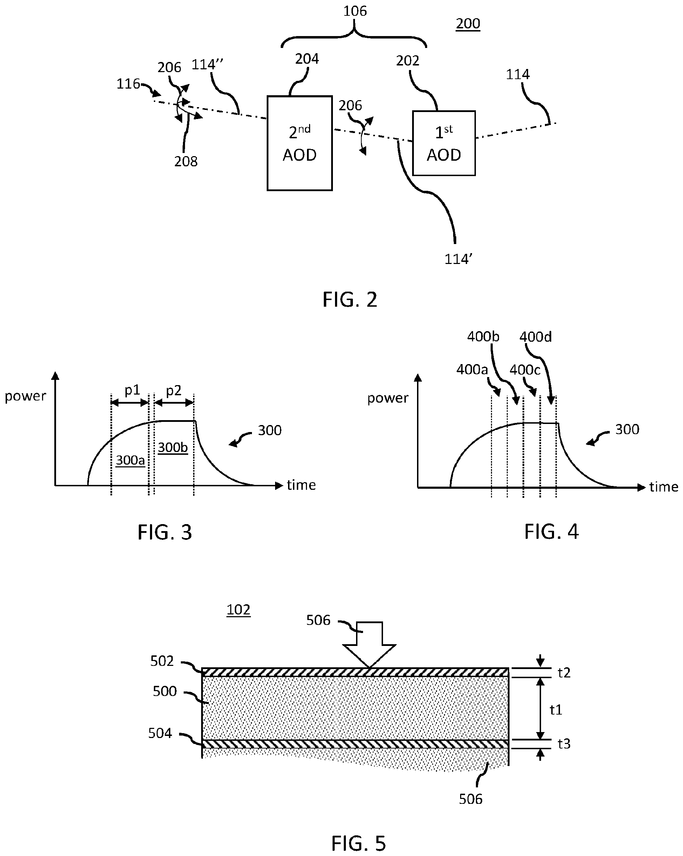

With reference to FIG. 2, the multi-axis AOD system may be provided as a multi-cell, multi-axis AOD system 200 that includes a first AOD 202 and a second AOD 204. Both the first AOD 202 and the second AOD 204 may be provided in any manner as described above. The first AOD 202 is arranged and operative to rotate an incident beam of laser energy (e.g., propagating along beam path 114) about a first rotation axis by any angle (e.g., as measured relative to the beam path 114 incident upon the first AOD 202) within a first range of angles (also referred to herein as a "first AOD angular range 206"), so as to transmit a first-order beam propagating along a deflected beam path 114'. Likewise, the second AOD 204 is arranged and operative to rotate an incident beam of laser energy transmitted by the first AOD 202 about a second rotation axis by any angle (e.g., as measured relative to the beam path 114' incident upon the second AOD 204) within a second range of angles (also referred to herein as a "second AOD angular range 208"), so as to transmit a first-order beam propagating along a deflected beam path 114". As will be appreciated, each of the beam path 114' and beam path 114" represent specific instances of a path along which the beam of laser energy can propagate; therefore, each of the beam path 114' and beam path 114" can also be generically referred to herein as "beam path 114."

Generally, the second AOD 204 is oriented relative to the first AOD 202 such that the second rotation axis is different from the first rotation axis. For example, the second rotation axis can be orthogonal to, or oblique relative to, the first rotation axis. Given that the diffraction axis of an AOD is orthogonal to the rotation axis of the AOD, the diffraction axis of the second AOD 204 (also referred to as the "second diffraction axis") can thus be orthogonal or oblique relative to the diffraction axis of the first AOD 202 (also referred to as the "first diffraction axis"). In another embodiment, however, the second AOD 204 is oriented relative to the first AOD 202 such that the second rotation axis is parallel to (or at least substantially parallel to) the first rotation axis. In this case, one or more optical components can be arranged in the beam path 114' to rotate the plane of deflection of the first AOD 202 (e.g., by 90 degrees, or thereabout) such that the plane of deflection of the first AOD 202, when projected onto the second AOD 204, is rotated (e.g., by 90 degrees, or thereabout) relative to the orientation of the plane of deflection of the second AOD 204, and the second diffraction axis can be parallel to (or at least substantially parallel to) to the first diffraction axis. See, e.g., Int'l. Pub. No. WO 2019/060590 A1 for examples of how the plane of deflection may be rotated as discussed above. Upon rotating the plane of deflection of the first AOD 202 in the manner described above, the first diffraction axis, as projected onto the second AOD 204, is rotated (e.g., by 90 degrees, or thereabout) relative to the orientation of the second diffraction axis.

Generally, the AO cells in the first AOD 202 is formed of a material that can be either the same as, or different from the AO cell in the second AOD 204. Further, the type of acoustic wave the first AOD 202 uses (i.e., shear-mode or longitudinal-mode) to deflect an incident beam of laser energy can be either same as, or different the type of acoustic wave the second AOD 204 uses to deflect an incident beam of laser energy.

It will be appreciated that the AOD system 200 can be operated at any time such that only the first AOD 202 generates a first-order beam, only the second AOD 204 generates a first-order beam, or both the first AOD 202 and the second AOD 204 generates a first-order beam. Accordingly, the deflection of the beam path 114 produced by the first positioner 106 can be considered to result from only the deflection obtained from beam path 114', from only the deflection obtained from beam path 114" or from the superposition of the deflections obtained from beam paths 114' and 114". Likewise, the primary angular range 116 can be considered to be only the first AOD angular range 206, only the second AOD angular range 208 or a superposition of the first AOD angular range 206 and the second AOD angular range 208. When the first positioner 106 is provided as an AOD system such as the AOD system 200, the first positioner 106 may optionally include one or more other additional optical components, such as a beam trap, beam expander, beam shaper, aperture, filter, collimator, lens, mirror, phase retarder, polarizer, or the like or any combination thereof.

IV. Discussion Concerning Diffraction Efficiency in AOD Systems

As used herein, the term "diffraction efficiency" refers to the proportion of energy in a beam of laser energy incident upon an AOD that gets diffracted within the AO cell of the AOD into the first-order beam. Diffraction efficiency may thus be represented as the ratio of the optical power in the first-order beam produced by the AOD to the optical power of the incident beam of laser energy incident upon the AOD. Generally, the amplitude of an applied RF drive signal can have a non-linear effect on the diffraction efficiency of the AOD, and the diffraction efficiency of an AOD can also change as a function of the frequency of the RF drive signal applied to drive the AOD. In view of the above, and in embodiments in which the first positioner 106 is provided as the aforementioned AOD system 200, a first RF drive signal applied to drive the first AOD 202 can be characterized as having an amplitude (also referred to herein as a "first amplitude") and a second RF drive signal applied to drive the second AOD 204 can be characterized as having an amplitude (also referred to herein as a "second amplitude").

Generally, the first amplitude can be selected or otherwise set based on one or more factors such as the first drive frequency of the first RF drive signal, the desired diffraction efficiency at which the first AOD 202 is to be driven by the first RF drive signal, the peak optical power of the beam of laser energy to be deflected during the period when the first AOD 202 is to be driven by the first RF drive signal, the average optical power of the beam of laser energy to be deflected during the period when the first AOD 202 is to be driven by the first RF drive signal, or the like or any combination thereof. Likewise, the second amplitude can be selected or otherwise set based on one or more factors such as the second drive frequency of the second RF drive signal, the desired diffraction efficiency at which the second AOD 204 is to be driven by the second RF drive signal, the peak optical power of the beam of laser energy to be deflected during the period when the second AOD 204 is to be driven by the second RF drive signal, the average optical power of the beam of laser energy to be deflected during the period when the second AOD 204 is to be driven by the second RF drive signal, or the like or any combination thereof.

V. Embodiments Concerning Pulse Slicing

As discussed above, the first positioner 106, whether provided as a single-axis AOD system or a multi-axis AOD system (such as AOD system 200), can be operated to effect pulse slicing, i.e., temporally-dividing a common laser pulse (also referred to herein as a "mother laser pulse") into at least two laser pulses. Temporally-divided portions of a common, mother laser pulse are also referred to herein as "pulse slices." As will be appreciated, a pulse slice can be considered a type of laser pulse.

One embodiment of pulse slicing is exemplarily illustrated in FIG. 3, in which a mother laser pulse 300 is temporally-divided into two pulse slices. Specifically, during a first slice period, p1, the mother laser pulse 300 is divided into a first pulse slice 300a and during a second slice period, p2, the mother laser pulse 300 is divided into a second pulse slice 300b. As will be appreciated, the pulse duration of a pulse slice generally corresponds to the duration of the slice period in which it was temporally-divided from its mother laser pulse. Thus, for example, the first pulse slice 300a can be characterized as having a pulse duration that is equal to the first slice period, p1, and the second pulse slice 300b can be characterized as having a pulse duration that is equal to the second slice period, p2. Further, as will be appreciated, the pulse duration of a pulse slice can correspond to (e.g., be equal to, or at least substantially equal to) the update rate of the first positioner 106 during pulse slicing, an integer multiple of the update rate of the first positioner 106 during pulse slicing, or a combination thereof.

Consecutive slice periods can occur continuously (i.e., with one slice period beginning immediately after a preceding slice period), can occur intermittently (i.e., with one slice period beginning subsequent to a delay immediately after a preceding slice period), or a combination thereof. In the case of consecutive slice periods occurring intermittently, it will be appreciated that the duration of the delay can be characterized as an integer multiple of the positioning period of the first positioner 106 (where the integer can be any integer such as 1, 2, 3, 4, 5, 10, 20, 50, 100, etc., or between any of these values). The embodiment shown in FIG. 3 is an example where consecutive slice periods p1 and p2 occur intermittently. In view of the above, it will be appreciated that the pulse slices output by the AOD system 200 can constitute a beam of laser energy having a pulse repetition rate that is equal to, or a multiple of, the update rate of the AOD system 200 when the AOD system 200 is operated to effect pulse slicing.

The total amount of time between the beginning of an initial slice period and the end of a last slice period to be applied to a common, mother laser pulse is less than or equal to the pulse duration (i.e., based on the full-width at half-maximum (FWHM) of the optical power in the pulse versus time) of the mother laser pulse. A mother laser pulse can be generally characterized as having a pulse duration that is greater than the positioning period of the first positioner 106. In some embodiments, the pulse duration of mother laser pulse is greater than, equal to, or less than 1 $\mu$s, 2 $\mu$s, 5 $\mu$s, 10 $\mu$s, 15 $\mu$s, 20 $\mu$s, 25 $\mu$s, 30 $\mu$s, 40 $\mu$s, 50 $\mu$s, 100 $\mu$s, 300 $\mu$s, 500 $\mu$s, 900 $\mu$s, 1 ms, 2 ms, 5 ms, 10 ms, 20 ms, 50 ms, 100 ms, 300 ms, 500 ms, 900 ms, 1 s, etc., or between any of these values.

In one embodiment, the duration of each slice period (and, thus, the pulse duration of each pulse slice) is an integer multiple of the positioning period of the first positioner 106 (e.g., where the integer is 1, 2, 3, 5, 10, etc., or between any of these values). In some embodiments, the duration of each slice period, is greater than, equal to or less than 200 $\mu$s, 125 $\mu$s, 100 $\mu$s, 50 $\mu$s, 33 $\mu$s, 25 $\mu$s, 20 $\mu$s, 13.3 $\mu$s, 12.5 $\mu$s, 10 $\mu$s, 4 $\mu$s, 2 $\mu$s, 1.3 $\mu$s, 1 $\mu$s, 0.2 $\mu$s, 0.1 $\mu$s, 0.05 $\mu$s, 0.025 $\mu$s, 0.02 $\mu$s, 0.013 $\mu$s, 0.01 $\mu$s, 0.008 $\mu$s, 0.0067 $\mu$s, 0.0057 $\mu$s, 0.0044 $\mu$s, 0.004 $\mu$s, etc., or between any of these values. Generally, the duration of one or more slice periods of a mother laser pulse can be equal, or different from, to the duration of one or more other slice periods of the same mother laser pulse. For example, although FIG. 3 illustrates the first slice period, p1, as being equal to the second slice period, p2, the duration of the first slice period, p1, may be greater than or less than the duration of the second slice period, p2.

Although FIG. 3 illustrates temporally-dividing a mother laser pulse 300 into only two pulse slices (i.e., the first pulse slice 300a and the second pulse slice 300b), it will be appreciated that the mother laser pulse 300 may be temporally-divided into more than two pulse slices (e.g., into 3 pulse slices, 5 pulse slices, 8 pulse slices, 10 pulse slices, 25 pulse slices, 30 pulse slices, 50 pulse slices, etc., or the like or between any of these values, etc.). For example, and with reference to FIG. 4, the laser pulse 300 may be temporally-divided into four pulse slices 400a, 400b, 400c and 400d. In one embodiment, operation of the first positioner 106 is controlled such that pulse slices within at least one pair of consecutively-divided pulse slices are deflected by different angles within the primary angular range 116. For example, the pulse slice 400a can be deflected (e.g., by a first angle) within the primary angular range 116, and then the pulse slice 400b can be deflected (e.g., by a second angle) within the primary angular range 116, and then the pulse slice 400c can be deflected (e.g., by a third angle) within the primary angular range 116, and then the pulse slice 400d can be deflected (e.g., by a fourth angle) within the primary angular range 116. In another embodiment, operation of the first positioner 106 is controlled such that pulse slices within at least one pair of consecutively-divided pulse slices are deflected by the same angle within the primary angular range 116.

Outside of slice periods, the first positioner 106 can be operated, in any manner known in the art, to attenuate an incident beam of laser energy such that the beam of laser energy propagating along the beam path 114, as ultimately deflected by the first positioner 106, has insufficient energy to process a workpiece 102. Additionally or alternatively, outside of slice periods, the first positioner 106 can be operated so as to deflect the beam path 114 to a beam trap, beam dump system, or the like or any combination thereof. Additionally or alternatively, outside of slice periods, operation of the first positioner 106 can be ceased to permit transmission of the incident beam of laser energy through an AOD of the first positioner 106 to a beam trap, beam dump system, or the like or any combination thereof.

Although pulse slicing has been discussed above with respect to a single mother laser pulse (i.e., laser pulse 300), it will be appreciated that the first positioner 106 may be operated to effect pule slicing with respect to a sequence of consecutively-propagating mother laser pulses. In the sequence, consecutive mother laser pulses may be temporally-divided in any desired manner, and two consecutive mother laser pulses may be temporally-divided in the same manner or in a different manner.

A. Additional Discussion Concerning Diffraction Efficiency

Within a slice period, the first positioner 106 can be operated to attenuate the incident beam of laser energy such that the optical power of a pulse slice is constant over time, varies over time, or any combination thereof. For example, an AOD (e.g., the first AOD 202, the second AOD 204, or a combination thereof) can be driven to attenuate an incident beam of laser energy by maintaining and/or varying the amplitude of the RF drive signal applied to the AOD during a slice period (e.g., while keeping the frequency of the applied RF drive signal constant). Thus, for example, the optical power of the first pulse slice 300a may be constant or variable for the duration of the first slice period, p1. Likewise, the optical power of the second pulse slice 300b may be constant or variable for the duration of the second slice period, p2.

Over consecutive slice periods during which a common mother laser pulse is temporally-divided into a plurality of pulse slices, the first positioner 106 can be operated to attenuate (e.g., by maintaining and/or varying the amplitude of the RF drive signal applied to an AOD over consecutive slice periods) the incident beam of laser energy such that the average optical power and/or the peak optical power of two is constant or variable. Thus, for example, the average optical power or peak optical power of the first pulse slice 300a during the first slice period, p1, may be greater than, equal to or less than the average optical power or peak optical power of the second pulse slice 300b during the second slice period, p2. In another example, the average optical power or peak optical power of pulse slice 400a may be greater than, equal to or less than the average optical power or peak optical power of any of pulse slices 400b, 400c and 400d; the average optical power or peak optical power of pulse slice 400b may be greater than, equal to or less than the average optical power or peak optical power of any of pulse slices 400c and 400d; and the average optical power or peak optical power of pulse slice 400c may be greater than, equal to or less than the average optical power or peak optical power of pulse slice 400d.

While discussion above concerning operation of the first positioner 106 to set or vary the optical power of pulse slices (i.e., when the first positioner 106 is operated to effect partial-pulse deflection), it will be appreciated that the first positioner 106 can be similarly operated to set or vary the optical power of deflected pulses of laser energy when the first positioner 106 is operated to effect whole-pulse deflection.

VI. Embodiments Concerning Beam Branching

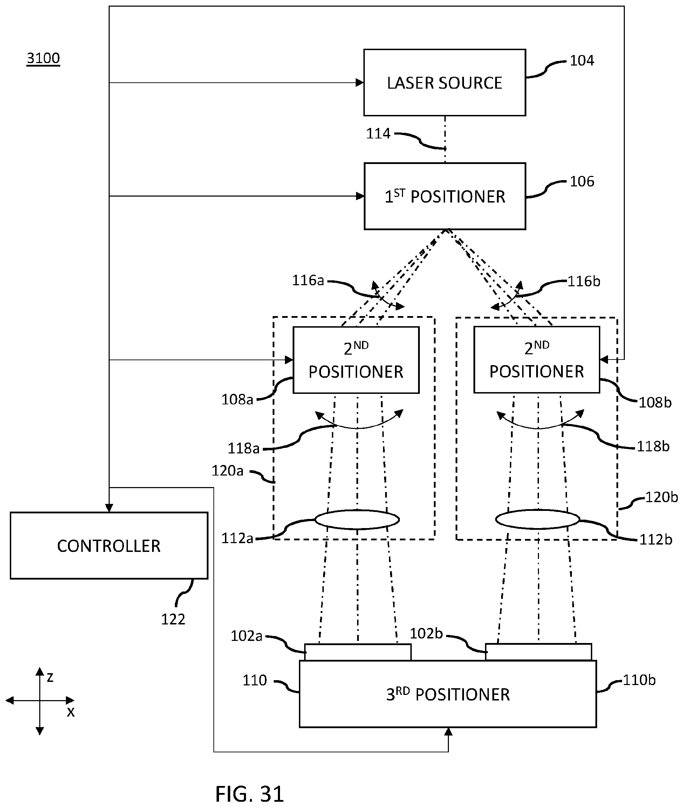

Although FIG. 1 illustrates an embodiment in which the laser-processing apparatus 100 includes a single second positioner 108, it will be appreciated that numerous embodiments disclosed herein can be applied to a laser-processing apparatus that includes multiple (i.e., two or more) second positioners 108. For example, and with reference to FIG. 31, a laser-processing apparatus 3100 may be provided in same manner as the aforementioned laser-processing apparatus 100, but may include multiple second positioners (e.g., second positioners 108a and 108b, each generically referred to as a "second positioner 108") and multiple scan lenses (e.g., scan lens 112a and 112b, each generically referred to as a "scan lens 112"). As with the laser-processing apparatus 100, a scan lens 112 and a corresponding second positioner 108 can, optionally, be integrated into a common housing or "scan head." Thus, scan lens 112a and a corresponding second positioner 108 (i.e., second positioner 108a) can be integrated into a common scan head 120a. Likewise, scan lens 112b and a corresponding second positioner 108 (i.e., second positioner 108b) can be integrated into a common scan head 120b. As used herein, each of scan head 120a and scan head 120b is also generically referred to herein as a "scan head 120."

When incorporated into the laser-processing apparatus 3100, the first positioner 106 may be operative to operative to diffract, reflect, refract, or otherwise deflect the beam of laser energy so as to deflect the beam path 114 to any of the second positioners 108. When deflecting the beam path 114 to the second positioner 108a, the beam path 114 can be deflected by any angle (e.g., as measured relative to the beam path 114 incident upon the first positioner 106) within a first range of angles (also referred to herein as a "first primary angular range 116a"). Likewise, when deflecting the beam path 114 to the second positioner 108b, the beam path 114 can be deflected by any angle (e.g., as measured relative to the beam path 114 incident upon the first positioner 106) within a second range of angles (also referred to herein as a "second primary angular range 116b"). As used herein, each of the first primary angular range 116a and the second primary angular range 116b can also generically referred to herein as a "primary angular range 116." Generally, the first primary angular range 116a does not overlap with, and is not contiguous with, the second primary angular range 116b. The first primary angular range 116a may be larger than, smaller than or equal to the second primary angular range 116b. As used herein, the act of deflecting the beam path 114 within one or more of the primary angular ranges 116 is referred to herein as "beam branching."

In one embodiment, the operation of the first positioner 106 can be controlled to deflect the beam path 114 to the second positioner 108a (e.g., during a first branch period) and then to deflect the beam path 114 to the second positioner 108b (e.g., during a second branch period following the first branch period), or vice-versa or any combination thereof. In another example, the operation of the first positioner 106 can be controlled to simultaneously deflect the beam path 114 to the second positioner 108a and the second positioner 108b. In the embodiments discussed herein, the duration of the first branch period may be greater than, less than, or equal to the duration of the second branch period. The duration of each of the first branch period and the second branch period can be greater than, equal to or less than the positioning period of the first positioner 106. In one embodiment, the duration of each of the first branch period and the second branch period can be characterized as an integer multiple of the positioning period of the first positioner 106 (where the integer can be any integer such as 1, 2, 3, 4, 5, 10, 20, 50, 100, etc., or between any of these values). See this section below for a further discussion regarding the "positioning period" of the first positioner 106. In some embodiments, the duration of each branch period, is greater than, equal to or less than 200 $\mu$s, 125 $\mu$s, 100 $\mu$s, 50 $\mu$s, 33 $\mu$s, 25 $\mu$s, 20 $\mu$s, 13.3 $\mu$s, 12.5 $\mu$s, 10 $\mu$s, 4 $\mu$s, 2 $\mu$s, 1.3 $\mu$s, 1 $\mu$s, 0.2 $\mu$s, 0.1 $\mu$s, 0.05 $\mu$s, 0.025 $\mu$s, 0.02 $\mu$s, 0.013 $\mu$s, 0.01 $\mu$s, 0.008 $\mu$s, 0.0067 $\mu$s, 0.0057 $\mu$s, 0.0044 $\mu$s, 0.004 $\mu$s, etc., or between any of these values.

When the beam of laser energy output by the laser source 104 is manifested as a series of laser pulses, each branch period may have a duration greater than or equal to the pulse duration of laser pulses within the beam of laser energy. In another embodiment, however, one or more branch periods may have a duration that is less than the pulse duration of laser pulses within the beam of laser energy. In such an embodiment (or, in embodiments in which the beam of laser energy output by the laser source 104 is manifested as a continuous or quasi-continuous laser beam), the act of beam branching can result in pulse slicing, thereby creating one or more pulse slices.

## VII. Feature Formation

Generally, the first positioner 106 - whether provided in either of the laser-processing apparatuses discussed with respect to FIGS. 1 or 31, or any other laser-processing apparatus - can be operated used to rapidly scan or otherwise place a process spot within the first scanning range (e.g., as discussed above) to form a feature (e.g., an opening, via, trench, slot, scribe line, recessed region, etc.) in a workpiece 102. In some embodiments, the workpiece 102 may be provided as a PCB panel, a PCB, an FPC, an IC, an ICP, a semiconductor device, etc. The workpiece 102 may thus include one or more constituent structures such as an electrical conductor structure (e.g., such as a film, foil, etc., which may be formed of copper, a copper alloy, an interconnect or wiring structure comprising one or more metals such as copper, titanium, titanium nitride, tantalum, etc., or the like or any combination thereof), a dielectric structure (e.g., a build-up film, a glass-reinforced epoxy laminate, an interlayer dielectric material, a low-k dielectric material, solder resist, a polymeric material, or the like or any combination thereof), or the like or any combination thereof. Any electrical conductor structure or dielectric structure of the workpiece 102 can have a thickness in a range from 5 $\mu$m (or thereabout) to 500 $\mu$m (or thereabout). Thus, a thickness of an electrical conductor structure or dielectric structure can be greater than, less than or equal to 0.5 $\mu$m, 0.1 $\mu$m, 1 $\mu$m, 3 $\mu$m, 5 $\mu$m, 10 $\mu$m, 15 $\mu$m, 18 $\mu$m, 20 $\mu$m, 25 $\mu$m, 30 $\mu$m, 35 $\mu$m, 40 $\mu$m, 50 $\mu$m, 70 $\mu$m, 80 $\mu$m, 100 $\mu$m, 110 $\mu$m, 120 $\mu$m, 250 $\mu$m, 300 $\mu$m, 350 $\mu$m, 400 $\mu$m, 450 $\mu$m, 550 $\mu$m, 600 $\mu$m, etc., or between any of these values.

In one embodiment, and with reference to FIG. 5, the workpiece 102 includes a dielectric structure 500 that is contacted by, or otherwise adhered to, a first electrical conductor structure 502 at a first side thereof. The dielectric structure 500 may be provided as a material such as FR4, polyimide, liquid crystal polymer, ABF, etc., and have a thickness ($t1$) in a range from 15 $\mu$m (or thereabout) to 120 $\mu$m (or thereabout). The first electrical conductor structure 502 may be provided as a copper or copper alloy foil, which may have an exposed surface that is either treated, e.g., by a chemical reaction, by a laser-darkening process, etc., to increase absorption of laser energy, or that is not darkened. A second electrical conductor structure 504 (e.g., a pad, a trace, foil, etc., formed of copper or a copper alloy, or the like) may be in contact with, or otherwise adhered to, a second side of the dielectric structure 500 that is opposite the first side. The first electrical conductor structure 502 may have a thickness ($t2$) equal to (or about equal to) 5 $\mu$m, 7 $\mu$m, 9 $\mu$m, 12 $\mu$m, 18 $\mu$m, 35 $\mu$m, 70 $\mu$m, 105 $\mu$m, etc. or between any of these values. If present, the second electrical conductor structure may have a thickness ($t3$) that is less than, greater than or equal to the thickness ($t1$) of the first electrical conductor structure 502. Optionally, the workpiece 102 may include one or more additional structures, such as an additional dielectric structure 508 shown partially in the FIG. 5), contacted by or otherwise adhered to the second electrical conductor structure 504 (e.g., such that the second electrical conductor structure 504 is interposed between the dielectric structure 500 and the dielectric structure 508).

Generally, the feature (e.g., an opening, via, trench, slot, scribe line, recessed region, etc.) can be characterized as being formed by removing material from one or more constituent structures of the workpiece 102 by way of ablation. Unless explicitly stated otherwise, the term "ablation" can refer to "direct ablation," "indirect ablation" or any combination thereof. Direct ablation of a material in the workpiece 102 occurs when the dominant cause of ablation is decomposition of the material due to absorption (e.g., linear absorption, nonlinear absorption, or any combination thereof) of energy within the beam of delivered laser energy by the material. Indirect ablation (also known as "lift off") of a target material in the workpiece 102 (e.g., the first electrical conductor) occurs when the dominant cause of ablation is melting and vaporization due to heat generated in, and transported from, an adjacent material (e.g., the dielectric structure 500) which absorbs the energy within the beam of laser energy that is ultimately delivered to the workpiece 102. Removal of the target material (e.g., the first electrical conductor 502) occurs when the pressure within a pocket of vaporized material (e.g., formed upon vaporization of the adjacent material) between the target material and the adjacent material is sufficient to eject the target material from the workpiece 102. Considerations concerning removal of material by indirect ablation are known in the art, and discussed in greater detail in Int'l.

Pub. No. WO 2017/044646 A1.

A. Feature Formation using Scan Patterns

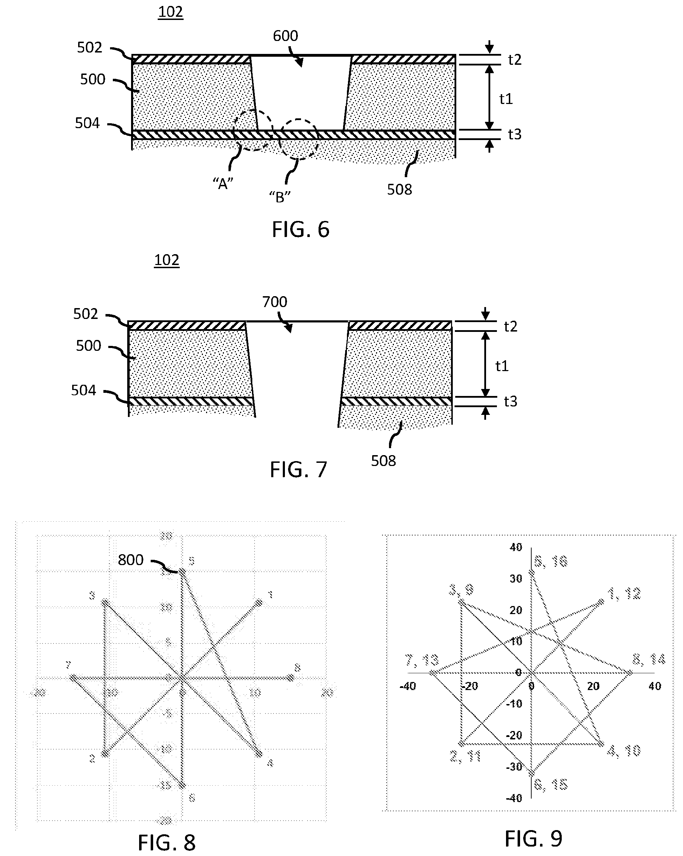

To form a feature such as a via (e.g., a blind-via 600, as exemplarily shown in FIG. 6, or a through-via 700, as exemplarily shown in FIG. 7) in the workpiece 102 (e.g., configured as described above), the first positioner 106 can be provided as a multi-axis AOD system (e.g., the AOD system 200) and be operated to scan a process spot (i.e., a spot on the workpiece 102 illuminated by a beam of laser energy directed onto the workpiece 102, as indicated by arrow 506 in FIG. 5) along a process trajectory that defines a scan pattern. When the beam of laser energy delivered to the workpiece 102 is manifested as a plurality of pulses, the scan pattern can be characterized as a pattern of spot locations distributed within area of the workpiece 102 where a feature (e.g., a via) is to be formed. During feature formation, the first positioner 106 can be operated so as to effect whole-pulse deflection or partial-pulse deflection (e.g., as discussed above), or a combination of whole- and partial-pulse deflection.

Generally, the maximum dimension of the scan pattern (as measured in the X-Y plane) is less than or equal to the maximum dimension of the first scan field (as measured in the X-Y plane). Moreover, the spot size of the process spot scanned along the scan pattern used to form the via will be less than the maximum dimension of the via itself (as formed in the first electrical conductor structure 502, and measured in the X-Y plane). Accordingly, the maximum dimension of the via may be equal to (or about equal to) 20 $\mu$m, 25 $\mu$m, 30 $\mu$m, 35 $\mu$m, 40 $\mu$m, 45 $\mu$m, 50 $\mu$m, 55 $\mu$m, 60 $\mu$m, 65 $\mu$m, 70 $\mu$m, 80 $\mu$m, 85 $\mu$m, 90 $\mu$m, 95 $\mu$m, 100 $\mu$m, 105 $\mu$m, 110 $\mu$m, etc., or between any of these values. The maximum dimension of the via, as formed in the dielectric structure (e.g., at the bottom of the via, or at or near an interface between the dielectric structure and the second electrical conductor structure, as measured in the X-Y plane), may be greater than, less than or equal to the maximum dimension of the via as formed in the first electrical conductor structure 502.

Characteristics of the scan pattern can include the number of spot locations in the scan pattern, the arrangement of spot locations in the scan pattern, the sequence or order in which spot locations in the scan pattern are addressed, the distance between consecutively-addressed spot locations, and the like. Generally, a spot location is addressed when either a single laser pulse or a single series of consecutively-delivered laser pulses is delivered to the workpiece 102 at the spot location. One or more of these scan pattern characteristics are selected or otherwise set in consideration of one or more or all the aforementioned characteristics of the beam of laser energy delivered to the workpiece 102 (e.g., wavelength, average power, pulse duration, pulse repetition rate, pulse energy, peak power, temporal optical power profile, spot size, etc.) so that laser energy is distributed uniformly (or at least somewhat uniformly) across the area of the workpiece 102 where the via is to be formed before the first electrical conductor structure 502 is ultimately ablated (i.e., due to indirect ablation, or a combination of direct ablation and indirect ablation). By doing so, a region of the first electrical conductor structure 502 where the via is to be formed is uniformly (or at least somewhat uniformly) heated to a temperature that is at or near the processing threshold temperature of the first electrical conductor structure 502 before all of the spot locations in the scan pattern have been addressed. Thus, a process of forming a via in the workpiece 102 includes a process of forming an opening in the first electrical conductor structure 502, whereby the opening is formed in the first electrical conductor structure 502 by first addressing a plurality of spot locations in a scan pattern to uniformly (or at least somewhat uniformly) heat a region of the first electrical conductor structure 502 where the opening is to be formed (i.e., to a temperature that is at or near the processing threshold temperature of the first electrical conductor structure 502) and, thereafter, addressing one or more other spot locations in the scan pattern to vaporize a portion of the dielectric structure 500 beneath the heated region of the first electrical conductor structure 502 to eject the heated region of the first electrical conductor structure 502 from the workpiece 102 (i.e., by indirect ablation).

In view of the above, it will be recognized that one or more of the aforementioned scan pattern characteristics as well as the characteristics of the beam of laser energy (e.g., average power, pulse duration, pulse repetition rate, pulse energy, peak power, spot size, or the like or any combination thereof) can be selected or otherwise set such that all of (at least substantially all of) the portion of the first electrical conductor structure 502 located within the area of the workpiece 102 where the via (including a region of the first electrical conductor structure 502 located at a center of the area of the workpiece 102 where the via is to be formed, also referred to herein as a "central region of the first electrical conductor 502") is melted before the first electrical conductor structure 502 is ablated (e.g., due to indirect ablation). However, one or more of these characteristics of the scan pattern, of the beam of laser energy, or a combination thereof can be modified such that the central region of the first electrical conductor 502 is not melted, but such that a portion of the first electrical conductor 502 surrounding the central region is melted, before the first electrical conductor structure 502 is ablated. In this case, the unmelted central region of the first electrical conductor 502 can still be removed by indirect ablation (e.g., upon vaporization of the dielectric structure beneath the unmelted central region of the first electrical conductor 502).

One or more of the scan pattern characteristics can also be selected or otherwise set in consideration of the rate with which consecutively-addressed spot locations in the scan pattern are addressed. The rate with which different spot locations in the scan pattern are addressed can be equal to (or at least substantially equal to) the update rate of the first positioner 106 during formation of the via, an integer multiple of the update rate of the first positioner 106 during formation of the via, or a combination thereof. Accordingly, the rate with which different spot locations in the scan pattern are addressed can correspond to the update rate of the first positioner 106 during formation of the via. Thus the total amount of time necessary to scan a process spot along a scan pattern (also referred to herein as "exposure time") can correspond to the product of the number of spot locations in the scan pattern multiplied by the first positioning period of the first positioner 106 (i.e., when the first positioner 106 is operated to scan the process spot along the scan pattern).

As noted above, during the process of forming a via, the laser energy is to be distributed uniformly (or at least somewhat uniformly) across an area of the workpiece 102 where the via is to be formed before the first electrical conductor structure 502 is ablated (e.g., due to direct ablation, indirect ablation, or a combination thereof). Accordingly, at least two spot locations (e.g., two, three, four, five, six, seven, eight, nine, ten, etc.) of a scan pattern will be addressed before the first electrical conductor structure 502 is ablated. For example, simulations conducted by the inventors indicate that, when a beam of laser energy manifested as a series of laser pulses (i.e., having a wavelength such as 9.4 $\mu$m or 10.6 $\mu$m, a spot size of 70 $\mu$m, a pulse duration of 1 $\mu$s, a peak power of up to about 1.3 kW) is directed onto a workpiece 102 provided as a PCB (i.e., such that the beam of laser energy is incident upon the first electrical conductor structure 502) having a dielectric structure formed of 50 $\mu$m-thick FR4, a first electrical conductor structure 502 formed of a 12 $\mu$m-thick copper foil, treated to increase absorption of laser energy, and a second electrical conductor structure formed of a 35 $\mu$m-thick copper foil, ablation of the first electrical conductor structure 502 begins within a period of 6 $\mu$s to 8 $\mu$s (or thereabout) after the process spot is initially scanned. Thus, according to this simulation, about six to eight spot locations can be addressed by the beam of laser energy before the first electrical conductor structure 502 is ablated.

i. Example Embodiments of Scan Patterns

What follows below is a discussion of scan patterns illustrated in FIGS. 8 to 22 and 24(a), which were developed by the inventors to form a circular (or at least roughly circular), blind-via in a workpiece 102 (e.g., provided as described above) using a beam of laser energy, as delivered to the workpiece 102, with a wavelength in a range from 9 $\mu$m (or thereabout) to 11 $\mu$m (or thereabout) (e.g., a wavelength of 9.4 $\mu$m (or thereabout), 10.6 $\mu$m (or thereabout), or the like), a peak power in a range from 250 W (or thereabout) to 2 kW (or thereabout) and a spot size in a range from 60 $\mu$m (or thereabout) to 90 $\mu$m (or thereabout). It will be appreciated, however, that the spot size could be smaller than 60 $\mu$m, e.g., in a range from 30 $\mu$m (or thereabout) to 60 $\mu$m (or thereabout). Thus, a process spot scanned along exemplary scan patterns as discussed below can have a spot size of, for example, 40 $\mu$m (or thereabout), 50 $\mu$m (or thereabout), 70 $\mu$m (or thereabout), or 85 $\mu$m (or thereabout), etc., or between any of these values. Generally, pulses in the beam of laser energy, as delivered to the workpiece 102, have a pulse duration of 1 $\mu$s (or thereabout). Nevertheless, it will be appreciated that the scan patterns described below may be used to form features other than blind-vias (e.g., though-vias trenches, slots, or other recesses or openings), and that the scan patterns may be modified to form features other than vias.

It will also be appreciated that the beam of laser energy, as delivered to the workpiece 102, may have a wavelength below 9 $\mu$m (e.g., in the ultraviolet or green-visible ranges of the electromagnetic spectrum), provided that other characteristics (e.g., pulse duration, pulse repetition rate, peak power, temporal optical power profile, fluence, etc.) of the beam of laser energy delivered to the workpiece 102 are sufficient to process the workpiece 102. For example, the laser source 104 may be provided as a laser such as the ULR/ULM-355-200 series of lasers manufactured by IPG PHOTONICS. These lasers are high power, QCW fiber lasers capable of producing a beam of laser energy at a wavelength of 355 nm and an average power of 200 W, wherein the beam is constituted by laser pulses having a pulse duration of about 1.4 ns output at a pulse repetition rate of 80 MHz. In another example, the laser source 104 may be provided as a laser such as the GPLN-532 series of lasers manufactured by IPG PHOTONICS (e.g., the GPLN-532-200, GPLN-532-500, etc.), which can be operated in pulsed or QCW mode and are capable of producing a beam of laser energy at a wavelength of 532 nm and an average power of 200 W or more, wherein the beam is constituted by laser pulses having a pulse duration of about 1.2 ns output at a pulse repetition rate of about 50 MHz or more.

Lastly it will be appreciated that, regardless, of the wavelength of the beam of laser energy as delivered to the workpiece 102, the beam of laser energy delivered to the workpiece 102 may have any suitable or desired characteristics (e.g., in terms of spot size, pulse duration, peak power, pulse energy, average power, pulse repetition rate, etc.) based on one or more factors such as material construction of the workpiece 102 being processed, acceptable quality and throughput standards, etc.

In FIGS. 8 to 22 and 24(a), the spot locations of any scan pattern are distributed in a circular arrangement (e.g., arranged on or along a common circumference of an imaginary circle). In these FIGS., the center of each spot location is designated by a dot or circle. The illustrated horizontally- and vertically-oriented axes are provided for reference, with the numbers at each axis indicating a distance or location (measured in μm). Accordingly, the scan patterns illustrated in FIGS. 8 to 22 and 24(a) can be characterized as having a radius in a range from 10 μm (or thereabout) to 60 μm (or thereabout).

In one embodiment, the scan pattern used to form the via may be a "farthest neighbor"-type scan pattern. In a farthest neighbor-type scan pattern, a second or subsequent spot location to be addressed is located as far as possible from any other previously-addressed spot location. Some examples of farthest neighbor-type scan patterns are illustrated in FIGS. 8 and 9.

Referring to FIG. 8, the farthest neighbor-type scan pattern consists of eight spot locations (wherein the center of each spot location is represented by a dot, such as dot 800), each of which is addressed only once. As exemplarily illustrated, the eight spot locations are provided in a circular arrangement (e.g., arranged on or along a common circumference of an imaginary circle). The lines connecting the spot locations, and the numbers "1," "2," ... "8" near the spot locations, indicate the sequence in which the spot locations in the scan pattern 800 are addressed (e.g., by the beam of laser energy, at least as deflected by the first positioner 106). Thus, spot location 1 is the first spot location in the scan pattern 800 to be addressed, spot location 2 is the second spot location in the scan pattern 800 to be addressed, etc., and spot location 8 is the last spot location in the scan pattern 800 to be addressed.

Referring to FIG. 9, the farthest neighbor-type scan pattern consists of sixteen spot locations provided in a circular arrangement (e.g., arranged on or along a common circumference of an imaginary circle). In the scan pattern shown in FIG. 9, each spot location overlaps with another spot location. Accordingly, the identifiers "1, 12" "2, 11" "3, 9" ... "5, 16" near the dots designate the spot locations, and the lines connecting the spot locations indicate the sequence in which the spot locations in the scan pattern are addressed (e.g., by the beam of laser energy, at least as deflected by the first positioner 106). Thus in the scan pattern shown in FIG. 9, the dot designated by "1, 12" represents the location of the first spot location in the scan pattern 800 to be addressed and the location of the twelfth spot location in the scan pattern 800 to be addressed; the dot designated by "2, 11" represents the location of the second spot location in the scan pattern to be addressed and the location of the eleventh spot location in the scan pattern to be addressed; and so on.

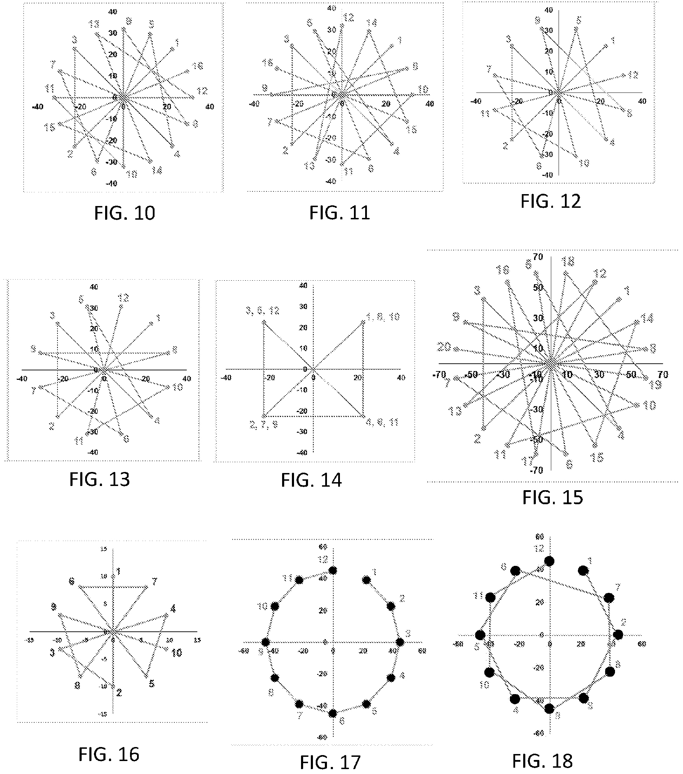

It will be appreciated that a farthest neighbor-type scan pattern can be modified (e.g., such that a second or subsequent spot location to be addressed is not located as far as possible from any other previously-addressed spot location) and still be suitable for use in forming a via. Some examples of modified farthest neighbor-type scan patterns are illustrated in FIGS. 10 to 22. The scan patterns shown in FIGS. 10 to 22 (as well as those shown in FIGS. 8 and 9) can be generally characterized as one of two types: a first type of scan pattern (also referred to herein as a "first-type scan pattern") in which the midpoints between certain pairs of consecutively-addressed spot locations are co-located (e.g., at the center of an imaginary circle); and a second type of scan pattern (also referred to herein as a "second-type scan pattern") in which the midpoints between no pairs of consecutively-addressed spot locations are co-located. FIGS. 8 to 16, 20 to 22 and 24(a) illustrate examples of first-type scan patterns; FIGS. 17 to 19 illustrate examples of second-type scan patterns.

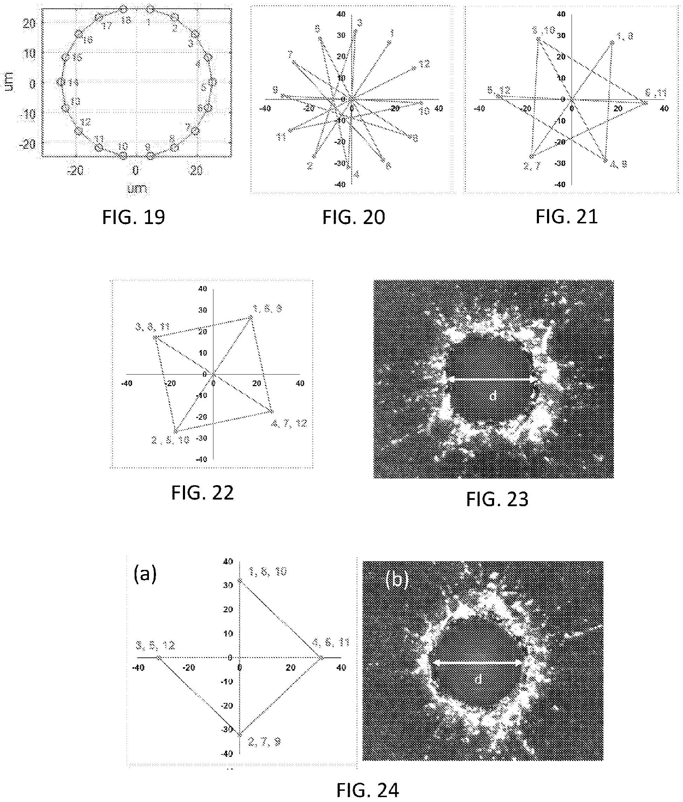

The second-type scan patterns can be characterized as scan patterns in which adjacent spot locations are consecutively addressed (e.g., as shown in FIGS. 17 and 19) or as scan patterns in which adjacent spot locations are not consecutively addressed (e.g., as shown in FIG. 18). Scan patterns such as those shown in FIGS. 17 and 19 are referred to as "consecutively-addressed second-type scan patterns" and scan patterns such as those shown in FIG. 18 are referred to as "non-consecutively-addressed second-type scan patterns."

In FIGS. 17 and 19, spot locations 1 and 2 are examples of spot locations that are adjacent to one another, and which are consecutively-addressed. In FIG. 18, spot locations 1 and 7 are examples of spot locations that are adjacent to one another, but are not consecutively-addressed. Rather, in FIG. 18, spot locations 1 and 2 are not adjacent to one another but are consecutively-addressed. In the example scan pattern shown in FIG. 18, spot location 7 is present (e.g., along a circumference of an imaginary circle) between spot locations 1 and 2, which are consecutively-addressed. As also shown in FIG. 18, spot locations 12 and 1 are present (e.g., along a circumference of an imaginary circle) between spot locations 6 and 7, which are consecutively-addressed. It will be appreciated that the scan patterns shown in FIGS. 17 to 19 can be modified such that any number of spot locations may be present (e.g., along a circumference of an imaginary circle) between any two consecutively-addressed spot locations in the same scan pattern.

While the example scan patterns illustrated in FIGS. 8 to 22 and 24(a) are shown to have a set number of spot locations (e.g., 4, 8, 12, 16, 18, or 20 spot locations) arranged on or along a common circumference of an imaginary circle, it will be appreciated that any scan pattern (whether illustrated or not) can have a different number of spot locations (e.g., 2, 3, 5, 6, 10, 15, 22, 25, 28, 30, 32, 40, 50, 60, 70, 75, 80, 100, etc., or between any of these values) arranged on or along a common circumference of an imaginary circle, and that the spot locations may be addressed in any suitable or desired sequence or order. For example, while the example scan patterns illustrated in FIGS. 8, 10 to 13 and 15-20 are shown to have a plurality of spot locations that are addressed, in sequence, only once, it will be appreciated that the spot locations of any of these scan patterns may be addressed, in sequence, multiple times (e.g., 2 times, 3 times, 4 times, 5 times, etc.). It will also be appreciated that spot locations within a common scan pattern may be arranged on or along any other line, perimeter, segment, etc., delineating any desired or suitable shape (e.g., triangle, square, rectangle, hexagon, oval, star, etc., or any combination thereof).

When scanning a process spot along a second-type scan pattern such that non-adjacent spot locations are consecutively-addressed, any number of spot locations may be present (e.g., along a circumference of an imaginary circle) between a pair of consecutively-addressed spot locations. The number of such spot locations that can be present between pairs of consecutively-addressed spot locations can be in a range from 3 spot locations to 10 spot locations (e.g., in a range from 4 spot locations to 6 spot locations).

ii. Additional Discussion Concerning Distortion of Feature Shape

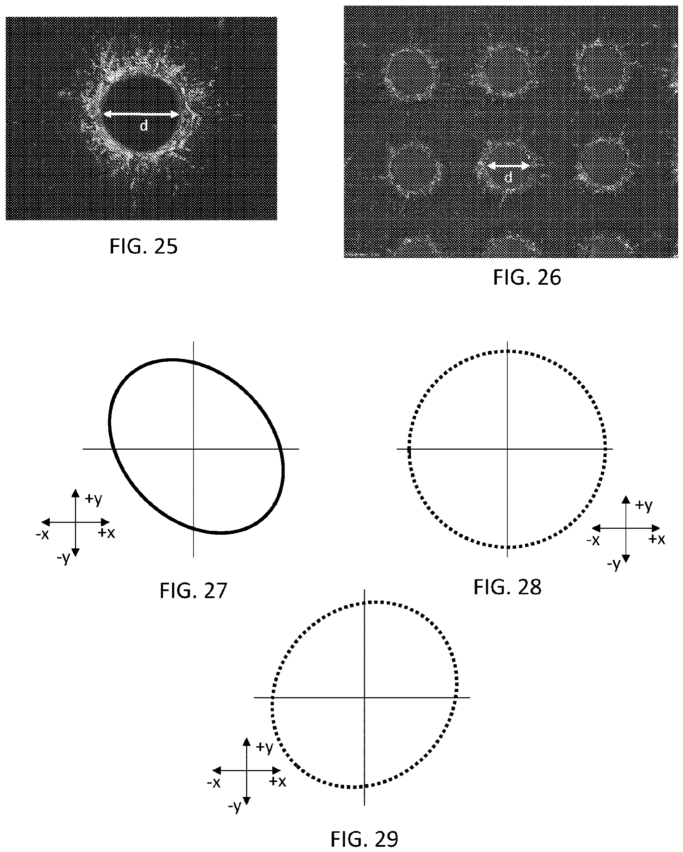

It has been discovered that vias, produced by operating the operating the first positioner 106 (e.g., a multi-axis AOD system, such as the AOD system 200) to scan a process spot along a second-type scan pattern as discussed above, can have an elliptical opening (i.e., at the surface of the workpiece 102), e.g., as shown in FIG. 27, even though the spot locations in the second-type scan pattern are arranged on or along the common circumference of an imaginary circle, e.g., as shown in FIG. 28). To compensate for this distortion in the shape of the via opening, the arrangement of the spot locations in the second-type scan pattern can be modified (e.g., such that the spot locations are arranged on or along the common perimeter of an imaginary ellipse, as shown in FIG. 29). The modified second-type scan pattern shown in FIG. 29 can generally be characterized as being elliptical in shape, wherein the major axis of the elliptical shape is orthogonal to the major axis of the shape of the via opening shown in FIG. 27. Any second-type scan pattern (including the aforementioned second-type scan patterns) can be modified such that the spot locations are arranged on or along the perimeter of a common ellipse instead of on or along a circumference of a common circle. Upon scanning a process spot along such a modified scan pattern, the opening of the via ultimately produced will have a shape that is more circular than the elliptical shape illustrated in FIG. 27.

iii. Additional Discussion Concerning Scan Patterns, Via Roundness & Pulse Slicing

It should be noted that, in FIGS. 8 to 22 and 24(a), the horizontally- and vertically-oriented axes do not necessarily represent the orientation of the diffraction axes of the AODs in the multi-axis AOD system (e.g., the AOD system 200) that is operated to scan the process spot along a scan pattern to form a via. Generally, the process spot can be scanned along any scan pattern such as that described herein while the while the AOD system 200 is operated to effect whole-pulse deflection, partial-pulse deflection (as discussed above, i.e., pulse slicing), or a combination thereof. When the multi-axis AOD system (e.g., the AOD system 200) is operated so as to effect partial-pulse deflection, it has been discovered that the roundness of the via opening ultimately formed can depend upon one or more factors such as the orientation of the scan pattern (i.e., the orientation of "jumps" between consecutively-addressed spot locations in a scan pattern relative to the orientation diffraction axes of the AODs in the multi-axis AOD system), the distance between consecutively-addressed spot locations in the scan pattern, and the update rate of the multi-axis AOD system while the process spot is scanned. While not wishing to be bound by any particular theory, the inventors believe that acoustic wave transients in the AO cell, present when the RF drive frequency applied to an AOD is varied while the laser pulse is transiting through the AO cell of the AOD during pulse slicing, diffract the incident beam of laser energy in undesired ways. Diffraction events caused by acoustic wave transients can sometimes result in unacceptable distortion of the process spot at the workpiece 102. It has been observed that the process spot distortions are most severe when the difference in RF drive frequencies applied to any particular AOD is large between two consecutive first positioning periods of the AOD. It has also been observed that process spot distortions can be reduced somewhat if multiple AODs in the multi-axis AOD system are operated to consecutively address different spot locations in a scan pattern.

For example, in the scan pattern shown in FIG. 14, the direction of the "jumps" between spot locations 1 and 2 (and between spot locations 7 and 8, and between spot locations 9 and 10) is parallel with one diffraction axis of an AOD in the multi-axis AOD system (e.g., the first diffraction axis of the first AOD 202 of the AOD system 200), and the direction of the "jumps" between spot locations 3 and 4 (and between spot locations 5 and 6, and between spot locations 11 and 12) is parallel with another diffraction axis of an AOD in the multi-axis AOD system (e.g., the second diffraction axis of the second AOD 204 of the AOD system 200). Accordingly, the distance between consecutively-addressed spots aligned along the diagonally-illustrated directions (each of which is parallel to the diffraction axes of an AOD in the multi-axis AOD system, such as AOD system 200) is greater than the distance between consecutively-addressed spots aligned along the horizontal or vertical directions illustrated in the FIG. Accordingly, when the process spot is scanned along the scan pattern shown in FIG. 14, the shape of the process spot at the workpiece 102 can be distorted to produce a via opening having a relatively poor roundness (e.g., as shown in FIG. 23). However, if the orientation of the scan pattern shown in FIG. 14 is rotated relative to the diffraction axes of the AODs in the multi-axis AOD system (e.g., by 45 degrees, as shown in FIG. 24(a)) so that the directions of the relatively large "jumps" (i.e., the jumps between spot locations 1 and 2, between spot locations 3 and 4, between spot locations 5 and 6, between spot locations 7 and 8, and between spot locations 9 and 10 and between spot locations 11 and 12) are not parallel with the diffraction axis of any AOD, then the roundness of the via opening ultimately produced can be improved, as shown in FIG. 24(b). Only a single AOD is operated to scan the process spot between spot locations 1 and 2 (and between spot locations 7 and 8, and between spot locations 9 and 10) or between spot locations 3 and 4 (and between spot locations 5 and 6, and between spot locations 11 and 12) as shown in FIG. 14. However, multiple AODs need to be operated to scan the process spot between spot locations 1 and 2, between spot locations 3 and 4, between spot locations 5 and 6, between spot locations 7 and 8, and between spot locations 9 and 10 and between spot locations 11 and 12 as shown in FIG. 24(a). Likewise, none of the directions of the "jumps" between consecutively-addressed spot locations in the scan pattern shown in FIG. 16 are parallel with the diffraction axis of any AOD within the multi-axis AOD system. As a result, when the process spot is scanned along the scan pattern shown in FIG. 16, the via ultimately produced has an opening with relatively good roundness (e.g., as shown in FIG. 25).

Note that, within an AOD, each applied RF drive frequency corresponds to an effective phase tilt applied to the incident beam of laser energy. In particular, the phase tilt (in μrad) can be calculated as follows:

$$phase\ tilt\ =\ \lambda * \Delta f / v$$

where $\lambda$ is the optical wavelength (measured in nm) of the beam of laser energy transiting the AOD, $\Delta f$ is the deviation (measured in Hz) of the applied RF drive frequency applied to the AOD from the center frequency of the AOD, and $v$ is the velocity (measured in m/s) of the acoustic wave in the AO cell. If, when the AOD system is operated to effect pulse slicing, the incident beam of laser energy is affected by multiple phase tilts (also referred to as multiple phase tilt sections) with significantly different magnitudes, distortion can be severe depending upon, for example, the update rate at which the AOD system 200 is operated. However, if pulse slicing is performed such that the multiple tilt sections differ in magnitude by small fractions of the wavelength of the beam of laser energy, distortion effects that would otherwise be observed can be reduced. This may also help to guide the selection and orientation of the scan pattern to be used, as well as the update rate of the multi-axis AOD system (e.g., the AOD system 200), when the multi-axis AOD system is operated so as to effect partial-pulse deflection when drilling a via.

For example, the direction of the "jumps" between spot locations 1 and 2 in the scan pattern shown in FIG. 8 is parallel with one diffraction axis of an AOD (e.g., the first diffraction axis of the first AOD 202 of the AOD system 200) and the direction of the "jumps" between spot locations 3 and 4 is parallel with another diffraction axis of an AOD (e.g., the second diffraction axis of the second AOD 204 of the AOD system 200). Thus, the longest jumps effected by a single AOD equal approximately 300 μrad of tilt - equivalent to approximately 4.5 μm of phase tilt over the diameter of the beam of laser energy transiting the AOD (which can be about 15 mm, or roughly 50% of its 9.4 μm wavelength). Thus, the jumps from spot location 1 to spot location 2, and from spot location 3 to spot location 4 are relatively large jumps.

In another example, when the AOD system 200 is operated to effect partial-pulse deflection to scan the process spot along scan pattern shown in FIG. 8 at an update rate of 1 MHz (corresponding to a first positioning period of 1 μs) a via with an acceptably round opening can be formed. However, when the update rate is doubled to 2 MHz (corresponding to a first positioning period of 0.5 μs) the process spot becomes distorted as it is scanned along the scan pattern shown in FIG. 8, resulting in formation of a via with an opening having a shape more closely resembling a square. In comparison, the distance of the jumps between consecutively-addressed spot locations in scan patterns such as those illustrated in FIGS. 17 to 19 can be much smaller than the distance of the jumps between consecutively-addressed spot locations in scan patterns such as that illustrated in FIG. 8. For example, the jumps between consecutively-addressed spot locations in the scan pattern shown in FIG. 19 can be less than 10 μm and (~ 3 times less than in the scan pattern shown in FIG. 8) and, as a result, distortion of the process spot at the workpiece 102 can be very low, when AODs in the multi-axis AOD system are driven at an update rate of 2 MHz and, further, even when driven at an update rate of 8 MHz (corresponding to a first positioning period of 0.125 μs).

In view of the above, a via can be formed (e.g., in the aforementioned workpiece 102) by operating the first positioner 106 (e.g., a multi-axis AOD system, such as the AOD system 200) at an update rate greater than 1 MHz (e.g., at an update rate greater than or equal to 2 MHz, 5 MHz, 8 MHz, 12 MHz, 25 MHz, 50 MHz, etc., or between any of these values) to scan a process spot (e.g., having a spot size in the range described above) along a second-type scan pattern (e.g., provided in any manner as described herein) having at a relatively large number (e.g., at least 40) of spot locations (e.g., 45, 50, 60, 75, 80, 90, 100, 124 spot locations, etc., or between any of these values) such that consecutively-addressed spot locations are spatially separated from another by up to six spot locations and/or such that the distance between the jumps of consecutively-addressed spot locations is less than 15 μm (e.g., 13 μm, 11 μm, 10 μm, 9 μm, 8 μm, 7 μm, etc., or between any of these values).

iv. Additional Discussion Concerning Localized Heat Accumulation

Depending upon one or more factors such as the wavelength, pulse duration, pulse repetition rate, peak power, average power, etc., of the laser pulses delivered to the workpiece 102, the linear absorption of a material at a spot location (e.g., relative to the wavelength of a laser pulse delivered to the spot location), the thermal conductivity, thermal diffusivity, specific heat capacity, etc., of the material at or near a spot location, the scan pattern along which a process spot is to be scanned, or the like or any combination thereof, the heat generated as a result of delivering laser pulses to one or more spot locations can diffuse from the irradiated spot location and accumulate within regions of the workpiece 102 outside the process spot, thereby increasing the temperature of the workpiece 102 at regions outside the process spot.

If the accumulated heat results in an increased temperature at a region of workpiece 102 located at or near a spot location to be irradiated by a process spot, and if the increased temperature is above a threshold temperature (i.e., a "processing threshold temperature"), then the efficiency with which the workpiece 102 can be subsequently processed (e.g., by direct ablation, indirect ablation, or any combination thereof) can be positively affected. Generally, the processing threshold temperature associated with a material to be processed is greater than or equal to the melting point or glass-transition temperature of the material to be processed, but less than the vaporization temperature thereof. In another embodiment, however, the processing threshold temperature may be less than the melting point or glass-transition temperature of the material to be processed (e.g., 98%, 95%, 93%, 90%, 89%, 87%, 85%, 80%, 75%, 70%, 65%, 50%, 40%, etc., or between any of these values, of the melting point or glass-transition temperature of the material to be processed).

In some cases, the accumulated heat can increase the temperature within regions of the workpiece 102 that are not intended to be processed (each also referred to herein as a "non-feature region" of the workpiece 102). If the temperature is high enough, a non-feature region of the workpiece 102 can become undesirably damaged (e.g., to become undesirably cracked, melted, delaminated, annealed, etc.). Thus it may be preferable to process the workpiece 102 in such a way that avoids undesirable accumulation of heat within non-feature regions of the workpiece 102. As used herein, the temperature at which a region of the workpiece 102 will become undesirably damaged is referred to as a "damage threshold temperature." It should be recognized that the damage threshold temperature of any non-feature region of the workpiece 102 may depend upon one or more factors such as the thickness, thermal conductivity, thermal diffusivity, specific heat capacity, etc., optical absorptivity (relative to the beam of delivered laser energy), etc., of any material at or near the spot location or in the non-feature region, as well as the thermal conductivity, thermal diffusivity, specific heat capacity, size and shape of structures located within the vicinity of the non-feature region, or the like or any combination thereof.

a. Avoiding Undesirable Damage

It has been discovered that, when forming a blind via 600 in the workpiece 102 (e.g., as described above with respect to FIGS. 5 and 6) by scanning a beam of laser energy (e.g., along a scan pattern exemplarily described above respect to FIGS. 8 to 29, or otherwise), the workpiece 102 can delaminate. Example regions where the workpiece 102 can delaminate include a region at the interface between the second electrical conductor structure 504 and one or both of the dielectric structure 500 and dielectric structure 508 at or near a peripheral area of the exposed second electrical conductor structure 504 (e.g., within the region identified by circle "A"), a region at the interface between the second electrical conductor structure 504 and the dielectric structure 508 at or near central area of the exposed second electrical conductor structure 504 (e.g., within the region identified by circle "B"), or the like or any combination thereof. Experiments performed by the applicant suggest that the delamination occurs when the laser pulses delivered to the workpiece 102 are of relatively high peak power. Near the end of the process of forming the blind via 600, the delivered laser pulses heat up the second electrical conductor structure 504 to a significant degree and the heat is then transferred from the second electrical conductor structure 504 into non-feature regions (e.g., within regions such as those identified by circles "A" and/or "B") of the dielectric structure 500 and/or dielectric structure 508 the adjacent to the heated second electrical conductor structure 504. The accumulated heat can raise the temperature of the adjacent regions of the dielectric structure 500 to above the glass transition temperature thereof (and, in some cases, above the decomposition temperature thereof), cause delamination within the workpiece 102 or make the workpiece 102 more susceptible to delamination.

To prevent delamination during the process of forming a blind via 600, the applicant has discovered that the peak power of the laser pulses directed to the workpiece 102 near the end of the process can be lower than the peak power of the laser pulses directed to the workpiece 102 earlier. The combination of reducing the peak power of delivered laser pulses and spatially distributing delivered laser pulses (e.g., along scan pattern exemplarily described above respect to FIGS. 8 to 29) has been found to prevent the second electrical conductor structure 504 from significantly heating up, thus preventing the adjacent regions of the dielectric structure 500 from undesirably accumulating heat which can contribute to delamination.

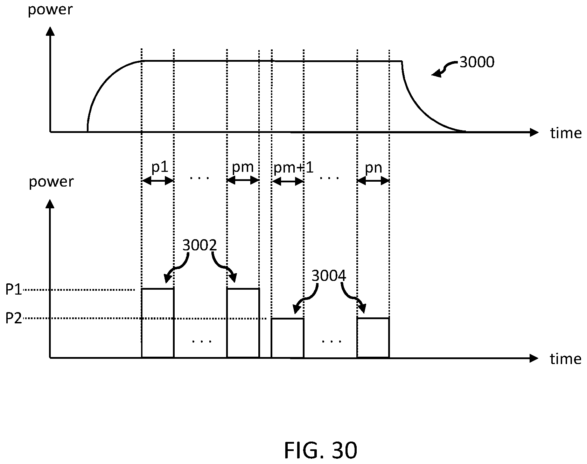

For example, and with reference to FIG. 30, a plurality of laser pulses to be delivered to the workpiece 102 to form the blind via 600 may be provided as pulse slices temporally-divided from a common mother laser pulse 3000 by the first positioner 106, and the pulse slices may be scanned along any suitable or desired scan pattern (e.g., as exemplarily described above respect to FIGS. 8 to 29, or otherwise). The mother laser pulse 3000 may have a wavelength in a range from 9 $\mu$m (or thereabout) to 11 $\mu$m (or thereabout) (e.g., a wavelength of 9.4 $\mu$m (or thereabout), 10.6 $\mu$m (or thereabout), or the like) and a peak power or average power in a range from 250 W (or thereabout) to 2 kW (or thereabout).

In this case, the pulse slices may include first pulse slices 3002 and second pulse slices 3004, in which a plurality of first pulse slices 3002 are delivered to the workpiece 102 during a first time period (e.g., which may be the total period of time from the beginning of a first slice period, p1, to the end of an $m^{th}$ slice period, pm) and, thereafter, a plurality of second pulse slices 3004 are delivered to the workpiece 102 during a second time period (e.g., which may be the total period of time from the beginning of a m+$1^{st}$ slice period, pm+1, to the end of an $n^{th}$ slice period, pn). Although FIG. 30 illustrates only two first pulse slices 3002 (i.e., corresponding to slice periods p1 and pm), it will be appreciated that any number of first pulse slices 3002 may be temporally-divided from the mother laser pulse 3000 between the first slice period, p1, and the $m^{th}$ slice period, pm. Likewise, although FIG. 30 illustrates only two second pulse slices 3004 (i.e., corresponding to slice periods pm+1 and pn), it will be appreciated that any number of second pulse slices 3004 may be temporally-divided from the mother laser pulse 3000 between the m+$1^{st}$ slice period, pm+1, and the $n^{th}$ slice period, pn. Consecutive slice periods during which pulse slices are temporally-divided from the mother laser pulse 3000 during the first time period can occur continuously, intermittently, or any combination thereof, as discussed above. Likewise, consecutive slice periods during which pulse slices are temporally-divided from the mother laser pulse 3000 during the second time period can occur continuously, intermittently, or any combination thereof, as discussed above. Further, although the $m^{th}$ slice period, pm, and the m+$1^{st}$ slice period, pm+1, are illustrated in FIG. 30 as occurring intermittently (i.e., with a delay intervening after the $m^{th}$ slice period, pm, and before the m+$1^{st}$ slice period, pm+1), it will be appreciated that the $m^{th}$ slice period, pm, and the m+$1^{st}$ slice period, pm+1, may occur continuously (i.e., with the m+$1^{st}$ slice period, pm+1, beginning immediately after the $m^{th}$ slice period, pm).

The first pulse slices 3002 may be characterized as having a substantially constant first optical power, P1, and the second pulse slices 3004 may be characterized as having a substantially constant second optical power, P2, which is less than the first optical power, P1. Generally, the optical power of the pulse slices may be set (e.g., to either the first optical power, P1, or to the second optical power, P2) by maintaining or varying the amplitude of the RF drive signal applied to the AOD during each slice period, as described above. In one embodiment, the first optical power P1 may be in range from 150 W (or thereabout) to 300 W (or thereabout) (e.g., 200 W, or thereabout). The second optical power P2 may be in range 75% to 25% of the first optical power P1 (e.g., 50%, or thereabout).

Laser pulses ultimately delivered to the workpiece during formation of the blind via 600 may have a spot size in a range from 60 $\mu$m (or thereabout) to 90 $\mu$m (or thereabout). It will be appreciated, however, that the spot size could be smaller than 60 $\mu$m, e.g., in a range from 30 $\mu$m (or thereabout) to 60 $\mu$m (or thereabout). Thus, a process spot scanned along exemplary scan patterns as discussed below can have a spot size of, for example, 40 $\mu$m (or thereabout), 50 $\mu$m (or thereabout), or 85 $\mu$m (or thereabout).

In one embodiment, the aforementioned first time period is less than the aforementioned second time period. For example, the first time period may be in a range from 4 $\mu$s (or thereabout) to 8 $\mu$s (or thereabout) and the second time period may be in a range from 8 $\mu$s (or thereabout) to 12 $\mu$s (or thereabout). In another embodiment, the first time period may be equal to, or greater than the second time period.

In one embodiment, the pulse duration of each of the first pulse slices 3002 is equal to (or at least substantially equal to) the pulse duration of each of the second pulse slices 3004. For example, the first pulse slices 3002 and the second pulse slices 3004 may each have a pulse duration of 1 $\mu$s (or thereabout). In another embodiment, however, the pulse duration of any of the first pulse slices 3002 is greater than or less than the pulse duration of any of the second pulse slices 3004.

Although FIG. 30 illustrates a pulse slicing technique involving two sets of pulse slices (i.e., the first pulse slices 3002 and the second pulse slices 3004) having different optical powers, it will be appreciated that the aforementioned pulse slicing technique may be modified to include one or more additional sets of pulse slices. Each additional set of pulse slices may comprise one or more pulse slices having an optical power that is different from the first optical power P1 or the second optical power P2, or may have an optical power that is different from the optical power of an immediately-preceding set of pulse slices.

b. Facilitating Removal of Relatively Thin Layers

It has been discovered that, when forming a via in the workpiece 102 (e.g., as described above with respect to FIGS. 5 and 6) by scanning a beam of laser energy (e.g., along a scan pattern exemplarily described above respect to FIGS. 8 to 29, or otherwise), the via opening - as formed in the first electrical conductor of the workpiece 102 - can have poor roundness if process spot illuminated by the beam of laser energy is scanned along scan patterns such as those described above with respect to FIGS. 8 to 22 and 24(a) if the thickness of the first electrical conductor structure 502 is relatively thin. For purposes of discussion, the first electrical conductor structure 502 can be considered to be "relatively thin" if it has a thickness of less than 5 $\mu$m (or thereabout). For example, a relatively thin first electrical conductor structure 502 can have a thickness less than or equal to 4.5 $\mu$m, 4 $\mu$m, 3 $\mu$m, 2.5 $\mu$m, 2 $\mu$m, 1.5 $\mu$m, 1 $\mu$m, etc., or between any of these values.

Indeed, as noted above, when a process spot illuminated by a beam of laser energy having a set of characteristics is scanned along a scan pattern such as any of those described above with respect to FIGS. 8 to 22 and 24(a) to remove a first electrical conductor structure 502 having a thickness of greater than 5 $\mu$m (e.g., greater than 5 $\mu$m, 7 $\mu$m, 9 $\mu$m, 12 $\mu$m, 18 $\mu$m, 35 $\mu$m, etc., or between any of these values), the laser energy laser energy can be distributed uniformly (or at least somewhat uniformly) across the area of the workpiece 102 where the via is to be formed before the first electrical conductor structure 502 is ablated. However, simulations performed by the applicant have shown that, when the same beam of laser energy (e.g., characterized by the same set of characteristics) is scanned along the same scan pattern, then the first electrical conductor structure 502 will become ablated before the process spot has been scanned along the entire scan pattern if the first electrical conductor structure 502 is relatively thin (as discussed above). Results of the simulations have been confirmed by experiments performed by the applicant.

To improve the roundness of a via opening formed in a relatively thin first electrical conductor structure 502 (e.g., during the process of forming a via (e.g., a blind via 600 or a through via 700), a scan pattern such as any of those described above with respect to FIGS. 8 to 22 and 24(a) may be modified to include one or more spot locations at or near the geometric centroid of the scan pattern (e.g., at or near the coordinates 0,0 as illustrated in any of FIGS. 8 to 22 or 24(a)). In this context, the spot locations of the scan patterns actually illustrated in FIGS. 8 to 22 or 24(a) are referred to herein as "heating spot locations," and the one or more spot locations at or near the geometric centroid of the scan pattern are herein referred to as "removal spot locations." The heating spot locations are addressed by the beam of laser energy in any suitable manner as described above with respect to FIGS. 8 to 22 or 24(a)), and the one or more removal spot locations are addressed thereafter. However, in addressing the heating spot locations, the beam of laser energy delivered to the workpiece 102 is characterized by a set of characteristics (e.g., in terms of peak power, pulse duration, pulse energy, etc.) sufficient to uniformly (or at least somewhat uniformly) heat the region of the first electrical conductor structure 502 where the via is to be formed to a temperature that is at or near the processing threshold temperature of the first electrical conductor structure 502 but insufficient to cause the heated first electrical conductor structure 502 to be ablated. Thereafter, one or more removal spot locations of the modified scan pattern are addressed using a beam of laser energy characterized by a set of characteristics (e.g., in terms of peak power, pulse duration, pulse energy, etc.) sufficient to ablate (e.g., by indirect ablation, direct ablation or a combination thereof) the heated region of the first electrical conductor structure 502.

In one embodiment, the peak power in one or more pulses of the beam of laser energy used to address a removal spot location is higher than the peak power in one or more pulses of the beam of laser energy used to address each of the heating spot locations. It will be appreciated that the peak power of each laser pulse, whether it addresses a removal spot location or a heating spot location, may be dependent upon the thickness of the first electrical conductor structure 502 (i.e., less peak power required as the thickness of the first electrical conductor structure 502 decreases). For example, for a first electrical conductor structure 502 having a thickness of 2 $\mu$m, any removal spot location may be addressed by a laser pulse having a peak power in a range from 1 kW (or thereabout) to 2 kW (or thereabout) and the heating spot locations may be addressed by laser pulses having a peak power in a range from 250 W (or thereabout) to 350 W (or thereabout). When the first electrical conductor structure 502 has a thickness of 1.5 $\mu$m, any removal spot location may be addressed by a laser pulse having a peak power in a range from, for example, 300 W (or thereabout) to 500 W (or thereabout) and the heating spot locations may be addressed by laser pulses having a peak power in a range from, for example, 150 W (or thereabout) to 250 W (or thereabout).

In another embodiment, the pulse duration of one or more pulses of the beam of laser energy used to address a removal spot location is greater than or equal to the pulse duration of each pulse used to address the heating spot locations. In general, however, the total amount of time during which the heating spot locations are addressed will be greater than the total amount of time during which the one or more removal spot locations are addressed. For example, the total amount of time during which the one or more removal spot locations are addressed may be in a range from 10% (or thereabout) to 25% (or thereabout) of the total amount of time during which the heating spot locations are addressed. It will be appreciated that the one or more removal spot locations may be addressed for more than 25% (or thereabout) of the total amount of time during which the heating spot locations are addressed (e.g., 30% to 60% of the total amount of time during which the heating spot locations are addressed). In this case, the energy in the laser pulse(s) delivered during the removal step would also be used to remove a portion of the dielectric structure 500.

In some embodiments, characteristics such as peak power, pulse duration of the beam of laser energy delivered to the workpiece 102 during heating and removal of the first electrical conductor structure 502 can be suitably modified by operating the first positioner 106 as discussed above.

## v. Further Discussion Concerning Distortion of Feature Shape

As discussed above, the scan patterns illustrated in FIGS. 8 to 22 and 24(a) can be characterized as having a radius in a range from range from 10 $\mu$m (or thereabout) to 60 $\mu$m (or thereabout). It will be appreciated that the radius of the scan pattern can be increased, provided that the scan pattern characteristics (e.g., number of spot locations in the scan pattern, the arrangement of spot locations in the scan pattern, the sequence or order in which spot locations in the scan pattern are addressed, the distance between consecutively-addressed spot locations, or the like or any combination thereof) and characteristics of the beam of laser energy delivered to the workpiece 102 (e.g., average power, pulse duration, pulse repetition rate, pulse energy, peak power, spot size, or the like or any combination thereof) are either maintained or modified so as to be sufficient to form a via having desirable characteristics, such as shape (e.g., roundness) of the via opening as formed in the first electrical conductor 502.

For example, if a consecutively-addressed second-type scan pattern such as that shown in FIG. 17 or 19 is modified to have a radius of greater than about 60 $\mu$m (e.g., 70 $\mu$m or greater), then the modified consecutively-addressed second-type scan pattern may, for example, include more spot locations (e.g., to maintain a desired pitch between adjacent spot locations, between consecutively-addressed spot locations, etc.). Optionally, one or more characteristics of the beam of laser energy delivered to the workpiece 102 (e.g., average power, pulse duration, pulse repetition rate, pulse energy, peak power, spot size, etc.) can also be modified to form a via having desirable characteristics, such as shape (e.g., roundness) of the via opening as formed in the first electrical conductor 502. However, in modifying a consecutively-addressed second-type scan pattern, it may be necessary to not simply include more spot locations (e.g., to maintain a desired pitch between adjacent spot locations, between consecutively-addressed spot locations, etc.) because a portion of the first electrical conductor between the first spot location and the last spot location in the scan pattern may still remain, producing a via opening having a poor roundness.

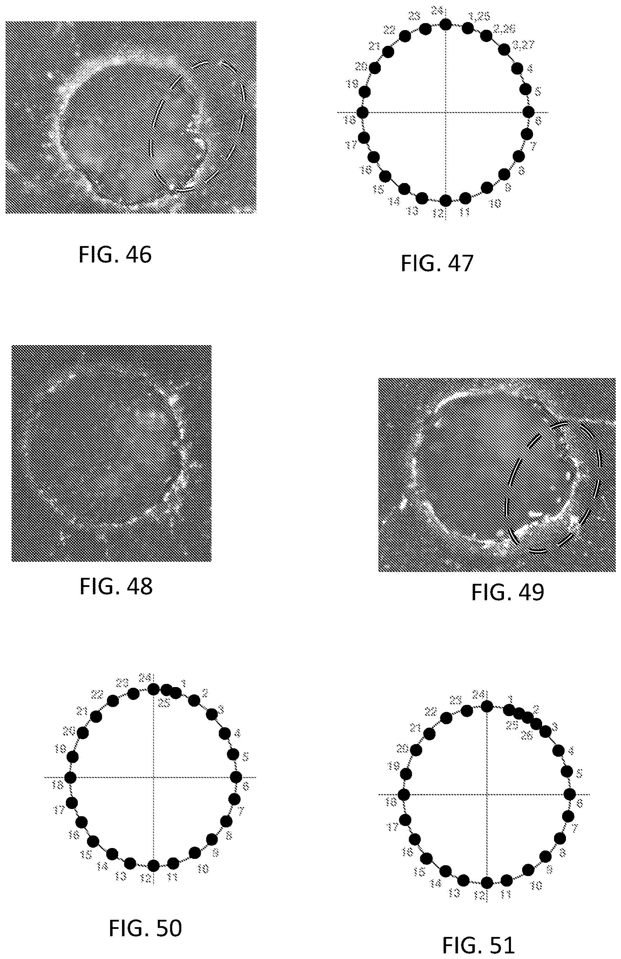

An example of a via opening formed in first electrical conductor (e.g., a copper layer) of a workpiece 102 having poor roundness is shown in the photomicrograph of FIG. 46. The via opening shown in FIG. 46 was formed by scanning a process spot (e.g., illuminated by a beam of laser energy having characteristics falling within the ranges described above with respect to the scan patterns shown in FIGS. 17 and 19) over the workpiece 102 along a consecutively-addressed second-type scan pattern similar to the scan patterns shown in FIGS. 17 and 19. Notably, however, the radius of the scan pattern was increased to 70 $\mu$m. In the photomicrograph shown in FIG. 46, the "tab" located within the dashed-region is the cause of the poor roundness of the via opening. While not wishing to be bound by any particular theory, it is believed that, by the time the last spot location was addressed, the temperature of a portion of the first electrical conductor 502 at or within the vicinity of the first spot location of the scan pattern was below the processing threshold temperature of the first electrical conductor 502. Thus, when the last spot location was addressed, there was not enough thermal energy within the first electrical conductor 502 at or near the first spot location to facilitate removal thereof.

In one embodiment, the roundness of the via opening in the first electrical conductor 502 may be improved by addressing one or more of the initially-addressed spot locations in the scan pattern after all of the other spot locations have been addressed. For example, with reference to the consecutively-addressed second-type scan pattern shown in FIG. 47, after the first to twenty-fourth spot locations 1-24 have been addressed, the location in the scan pattern designated by the first spot location 1 is addressed again (hence, the dot designated by "1, 25" represents the location of the first spot location and the twenty-fifth spot location in the scan pattern). Optionally, other spot locations, which were previously addressed, can be addressed after the twenty-fifth spot location. For example, and again with reference to FIG. 47, spot location 2 is addressed after addressing spot location 25, (hence, the dot designated by "2, 26" represents the location of the second spot location and the twenty-sixth spot location, which overlap one another), and spot location 3 may be addressed after addressing spot location 26, (hence, the dot designated by "3, 27" represents the location of the third spot location and the twenty-seventh spot location, which overlap one another). As used herein, spot locations that overlap one another (e.g., as discussed above) are herein referred to as "consecutively-addressed second-type scan pattern overlapping spot locations." For any consecutively-addressed second-type scan pattern overlapping spot location, the spot location that is addressed last is referred to as a "last-addressed overlapping spot location." Thus, at the spot location designated by "1, 25," spot location 25 can be referred to as a "last-addressed overlapping spot location," at the spot location designated by "2, 26," spot location 26 can be referred to as a "last-addressed overlapping spot location," and so on.

In the context of maintaining a desirable roundness of the via opening in the first electrical conductor, an appropriate consecutively-addressed second-type scan pattern will provide the first spot location as a consecutively-addressed second-type scan pattern overlapping spot location, and one or more consecutively-addressed spot locations following first spot location may also be provided as consecutively-addressed second-type scan pattern overlapping spot locations. Accordingly, the number of consecutively-addressed second-type scan pattern overlapping spot locations that may be included in a second-type scan pattern can be equal to 1, 2, 3, 4, 5, etc. Instead of specifying the number of consecutively-addressed second-type scan pattern overlapping spot locations included in a second-type scan pattern, the number of consecutively-addressed second-type scan pattern overlapping spot locations that may be included in a second-type scan pattern can be represented as a percentage of the total number of spot locations in the second-type scan pattern. In this case, the consecutively-addressed second-type scan pattern overlapping spot locations can constitute up to 12% (or thereabout) of the total number of spot locations in the second-type scan pattern. For example, the percentage can be 1%, 2%, 3%, 4%, 5%, 6%, 7%, 8%, 9%, 10%, 11%, 12%, 13%, etc., or between any of these values. Ultimately, however, the number of consecutively-addressed second-type scan pattern overlapping spot locations to be included in a second-type scan pattern may depend on one or more factors such as any of the aforementioned scan pattern characteristics, any of the characteristics of the beam of laser energy delivered to the workpiece 102 (e.g., wavelength, average power, pulse duration, pulse repetition rate, pulse energy, peak power, optical intensity, fluence, spot size, etc.), characteristics of the workpiece 102 (e.g., thickness of the first electrical conductor, etc.), or the like or any combination thereof. By providing a consecutively-addressed second-type scan pattern as described above with respect to FIG. 47, a region of the first electrical conductor at or near the first spot location (i.e., spot location 1) can accumulate sufficient thermal energy to facilitate removal thereof, thereby yielding a via opening in the first electrical conductor with good roundness (e.g., as shown in FIG. 48). It should be noted that, if too many spot locations are provided as consecutively-addressed second-type scan pattern overlapping spot locations, then the first electrical conductor may become excessively processed, again yielding a via opening in the first electrical conductor with poor roundness, as shown in FIG. 49.

Thus far, the distance between each pair of consecutively-addressed spot locations in a consecutively-addressed second-type scan pattern, such as any of those described with respect to FIGS. 17 and 19, is the same (or at least about the same). For example, the distance between spot locations 3 and 4 in any of FIGS. 17 or 19, is the same as (or about the same as) the distance between spot location 1 and the last spot location (i.e., spot location 12 in FIG. 17, and spot location 18 in FIG. 19). In the context of maintaining a desirable roundness of the via opening in the first electrical conductor, an appropriate consecutively-addressed second-type scan pattern can be configured such that the distance between pair of consecutively-addressed spot locations containing the last spot location to be addressed can be less than the distance by which the rest of the pairs of consecutively-addressed spot locations are separated. For example, with reference to FIG. 50, the distance between spot locations 24 and 25 can be less than the distance between spot locations 1 and 2, between spot locations 10 and 11, etc. Generally, the distance between the last two spot locations to be addressed (e.g., between spot locations 24 and 25) can be in a range between 30% (or thereabout) and 99% (or thereabout) of the distance between any other pair of consecutively-addressed spot locations. By providing a consecutively-addressed second-type scan pattern as described above with respect to FIG. 50, a region of the first electrical conductor at or near the first spot location (i.e., spot location 1) can accumulate sufficient thermal energy to facilitate removal thereof, thereby yielding a via opening in the first electrical conductor with good roundness.

In another embodiment, a consecutively-addressed second-type scan pattern can be modified to include one or more spot locations between at least one pair of consecutively-addressed spot locations. Thus, consecutively-addressed spot locations in one portion of the second-type scan pattern may be adjacent to one another (e.g., as with a consecutively-addressed second-type scan pattern) and consecutively-addressed spot locations in another portion of the second-type scan pattern may not be adjacent to one another (e.g., as with a non-consecutively-addressed second-type scan pattern). This type of second-type scan pattern is herein referred to as a "hybrid second-type scan pattern." An example of a hybrid second-type scan pattern is shown in FIG. 51. Referring to FIG. 51, the hybrid second-type scan pattern may include spot location 25 (which is addressed consecutively after spot location 24) arranged between spot locations 1 and 2 the distance between spot locations 24 and 25. Although FIG. 51 illustrates only one spot location (i.e., spot location 25) between spot locations 1 and 2, it will be appreciated that multiple spot locations may be arranged between spot locations 1 and 2 or any other pair of consecutively-addressed spot locations. Optionally, the hybrid second-type scan pattern may further include one or more additional spot locations, such as spot location 26 (which is addressed consecutively after spot location 25) arranged between one or more additional pairs of consecutively-addressed spot locations, such as between spot location 2 and 3. By providing a hybrid second-type scan pattern as described above with respect to FIG. 51, a region of the first electrical conductor at or near the first spot location (i.e., spot location 1) can accumulate sufficient thermal energy to facilitate removal thereof, thereby yielding a via opening in the first electrical conductor with good roundness (e.g., like shown in FIG. 48). Ultimately, however, the number of spot locations to be added between a pair of consecutively-addressed spot locations, or the number of pairs of consecutively-addressed spot locations to have spot locations therebetween, may depend on one or more factors such as any of the aforementioned scan pattern characteristics, any of the characteristics of the beam of laser energy delivered to the workpiece 102 (e.g., wavelength, average power, pulse duration, pulse repetition rate, pulse energy, peak power, optical intensity, fluence, spot size, etc.), characteristics of the workpiece 102 (e.g., thickness of the first electrical conductor, etc.), or the like or any combination thereof. It should be noted that, if too many spot locations are provided between a pair of consecutively-addressed spot locations, or that if too many pairs of consecutively-addressed spot locations have one or more spot locations therebetween, then the first electrical conductor may become excessively processed, yielding a via opening in the first electrical conductor with poor roundness (e.g., like shown in FIG. 49).

Although second-type scan patterns having relatively large radii and useful in producing vias with openings having good roundness have been separately discussed above with respect to FIGS. 47, 50 and 51, it should be recognized that characteristics unique to each of the types of second-type scan patterns may be combined in any suitable or desired manner.

### B. Feature Formation by Punch Processing

To form a feature such as a via (e.g., a blind-via 600, as exemplarily shown in FIG. 6, or a through-via 700, as exemplarily shown in FIG. 7) in the workpiece 102 (e.g., configured as described above), the first positioner 106 can be provided as a multi-axis AOD system (e.g., the AOD system 200) and be operated to repetitively generate a process spot at the same (or substantially same) location at the workpiece 102. As used herein, the term "punch processing" refers to the act of delivering a set of laser pulses to the same (or substantially same) spot location at the workpiece 102 to form a feature (e.g., a via or other opening). During punch processing (e.g., to form a feature such as a via or other opening), the first positioner 106 can be operated so as to effect whole-pulse deflection or partial-pulse deflection (as discussed above, i.e., pulse slicing), or a combination of whole- and partial-pulse deflection.

The first positioner 106 can be operated during punch processing (e.g., to form a feature such as a via or other opening) so as to prevent material of the workpiece 102 (e.g., the dielectric structure 500) from heating excessively (i.e., as a result of being irradiated by laser pulses) or otherwise preventing the workpiece 102 (or one or more constituent structures of the workpiece 102) from being undesirably warped, delaminated, or otherwise modified. As will be discussed in greater detail below, the first positioner 106 can be operated during punch processing to ensure that laser pulses within at least one pair of consecutive laser pulses in the set of laser pulses are delivered intermittently (i.e., with one laser pulse beginning subsequent to a delay immediately after a preceding laser pulse), to modify the optical power of a laser pulse relative to another laser pulse in the set of laser pulses, to modify the pulse duration of a laser pulse relative to another laser pulse in the set of laser pulses, or the like or any combination thereof.

### i. Example Embodiments Concerning Pulse Slicing

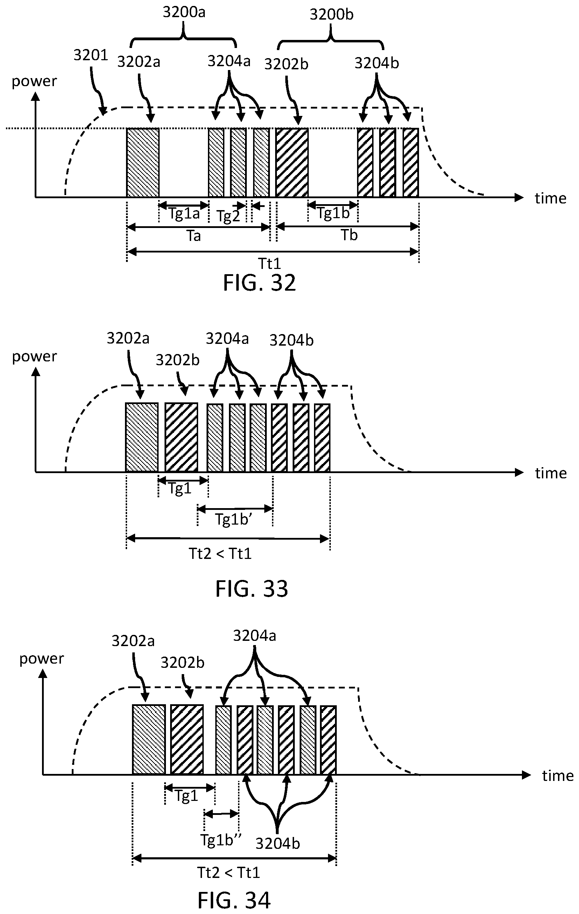

Referring to FIG. 32, the first positioner 106 can be operated during punch processing to temporally-divide a mother laser pulse (e.g., mother laser pulse 3201) into a plurality of pulse slices. Thus, the first positioner 106 can be operated to deflect pulse slices within at least one pair of consecutively-divided pulse slices by the same angle (or at least substantially the same angle) within the primary angular range 116. It will be appreciated that the plurality of pulse slices can, themselves, be grouped into a plurality of sets of pulse slices (e.g., sets 3200a and 3200b of pulse slices, each generically referred to as a "set 3200 of pulse slices"). In this case, the first positioner 106 can be operated to deflect pulse slices within a common set 3200 of pulse slices by the same angle (or at least substantially the same angle) within the primary angular range 116, and to deflect pulse slices within different sets 3200 of pulse slices by different angles (or at least substantially different angles) within the primary angular range 116. For example, the first positioner 106 can be operated to deflect pulse slices within set 3200a of pulse slices by a first angle within the primary angular range 116 shown in FIG. 1 (or by an angle within first primary angular range 116a shown in FIG. 31), and to deflect pulse slices within set 3200b of pulse slices by a second angle within the primary angular range 116 shown in FIG. 1 (or by an angle within the second primary angular range 116b shown in FIG. 31). It will be appreciated, however, that the pulse slices within sets 3200a and 3200b of pulse slices can be considered a common set of pulse slices and, so, all pulse slices sets 3200a and 3200b of pulse slices can be deflected to the same (or at least substantially the same) angle within a primary angular range 116. As exemplarily illustrated, at a given point in time, the power of a pulse slice is less than the power of the mother laser pulse 3201 from which it was temporally-divided. The disparity in power, as between, the mother laser pulse 3201 and a pulse slice can be the result of the diffraction efficiency of one or more AODs in the first positioner 106 when the first positioner 106 is operated to generate the pulse slices, the inherent optical loss associated with use of the AODs in the first positioner 106, or the like or any combination thereof.

In the illustrated embodiment, the set 3200a of pulse slices includes a primary pulse slice 3202a and a plurality secondary pulse slices 3204a. Likewise in the illustrated embodiment, the set 3200b of pulse slices includes a primary pulse slice 3202b and a plurality secondary pulse slices 3204b. As used herein, each of primary pulse slices 3202a and 3202b can be generically referred as a "primary pulse slice 3202" and each of the secondary pulse slices 3204a and 3204b can be generically referred as a "secondary pulse slice 3204." In the illustrated embodiment, the pulse duration and pulse energy of a primary pulse slice 3202 is greater than the pulse duration and pulse energy of each secondary pulse slice 3204. In other embodiments, however, the set 3200a of pulse slices can includes multiple primary pulse slices 3202a and one or more secondary pulse slices 3204a. Likewise in other embodiments, the set 3200b of pulse slices can include multiple primary pulse slices 3202b and one or more secondary pulse slices 3204b.

In one embodiment, the primary pulse slice 3202 is generally used to ablate (i.e., via direct ablation, indirect ablation, or a combination thereof) the first electrical conductor structure 502 of the workpiece 102. In this case, the pulse duration and pulse energy of a single primary pulse slice 3202 is sufficient to ablate the first electrical conductor structure 502 of the workpiece 102. In another case, the pulse duration and pulse energy of each of multiple primary pulse slices 3202 in a common set 3200 of pulse slices is sufficient such that ablation of the first electrical conductor structure 502 is effected by the multiple primary pulse slices 3202. In another embodiment, however, if the first electrical conductor structure 502 is not present on the workpiece 102 at the desired spot location, then one or more primary pulse slices 3202 can be used to ablate (i.e., via direct ablation, indirect ablation, or a combination thereof), the dielectric structure 500 of the workpiece 102. It should be noted that the pulse duration, pulse energy, peak optical power, temporal optical power profile (e.g., rectangular, as shown by the various pulse slices in FIG. 32) of at least one primary pulse slice 3202 in a set of pulse slices may be greater than, lesser than, or the same as, the pulse duration, pulse energy, peak optical power, temporal optical power profile (e.g., rectangular, as shown by the various pulse slices in FIG. 32) of any other primary pulse slice 3202 in the same set of pulse slices.

In one embodiment, each secondary pulse slice 3204 is generally used to remove the dielectric structure 500 of the workpiece 102 without significantly processing the second electrical conductor structure 504 (e.g., to form a blind-via, such as blind-via 600). In this case, the pulse duration and pulse energy of each secondary pulse slice 3204 is sufficient to remove (e.g., via ablation, vaporization, melting, or the like or any combination thereof) the first electrical conductor structure 502 of the workpiece 102 and the pulse duration and/or pulse energy of at least the last secondary pulse slice 3204 is sufficient to remove the dielectric structure 500 of the workpiece 102 without significantly processing the second electrical conductor structure 504. Thus, the pulse duration, pulse energy, peak optical power, temporal optical power profile (e.g., rectangular, as shown by the various pulse slices in FIG. 32) of at least one secondary pulse slice 3204 in a set of pulse slices may be greater than, lesser than, or the same as, the pulse duration, pulse energy, peak optical power, temporal optical power profile (e.g., rectangular, as shown by the various pulse slices in FIG. 32) of any other secondary pulse slice 3204 in the same set of pulse slices.

In another embodiment, one or more secondary pulse slices 3204 can be used to ablate (i.e., via direct ablation, indirect ablation, or a combination thereof), second electrical conductor structure 504 of the workpiece 102. In this case, one or more secondary pulse slices 3204 delivered to the workpiece 102 after the second electrical conductor structure 504 has been ablated can be used to remove (e.g., via ablation, vaporization, melting, or the like or any combination thereof) the dielectric structure 508 (e.g., to form a through-via, such as through-via 700). Thus, the pulse duration, pulse energy, peak optical power, temporal optical power profile (e.g., rectangular, as shown by the various pulse slices in FIG. 32) of at least one secondary pulse slice 3204 in a set of pulse slices may be greater than, lesser than, or the same as, the pulse duration, pulse energy, peak optical power, temporal optical power profile (e.g., rectangular, as shown by the various pulse slices in FIG. 32) of any other secondary pulse slice 3204 in the same set of pulse slices.

In yet another embodiment, however, sets 3200a and 3200b of pulse slices can be used to form a through-via (e.g., through-via 700). In this case, the set 3200a of pulse slices can be used to sequentially remove material from the first electrical conductor structure 502 and dielectric structure 500 and the set 3200b of pulse slices can be used to sequentially remove material from the second electrical conductor structure 504 and dielectric structure 508.

In yet another embodiment, if the dielectric structure 500 is an inhomogenous material (e.g., FR4, which is known to be a glass-reinforced epoxy laminate containing, for example a woven fiberglass cloth within an epoxy resin matrix), and if a portion the dielectric structure 500 at the desired spot location of the workpiece 102 contains an amount of glass material, then the pulse duration and pulse energy of at least one secondary pulse slice 3204 intended to remove the glass material can be modified relative to the pulse duration and pulse energy of at least one other secondary pulse slice 3204 intended only to remove the epoxy resin, such that the glass material can be efficiently removed (e.g., via ablation, vaporization, melting, or the like or any combination thereof) at the desired spot location. Thus, the pulse duration, pulse energy, peak optical power, temporal optical power profile (e.g., rectangular, as shown by the various pulse slices in FIG. 32) of at least one secondary pulse slice 3204 in a set of pulse slices may be greater than, lesser than, or the same as, the pulse duration, pulse energy, peak optical power, temporal optical power profile (e.g., rectangular, as shown by the various pulse slices in FIG. 32) of any other secondary pulse slice 3204 in the same set of pulse slices.

If, during punch processing, consecutive laser pulses are delivered intermittently, the first positioner 106 can be operated to ensure that the amount of time between the beginning of one laser pulse and the end of a preceding laser pulse (also referred to herein as a "gap time") is sufficient to allow the material at or near the spot location to cool somewhat (e.g., to below a damage threshold temperature of the material) before the next laser pulse is delivered. For example, and with reference to FIG. 32, the first positioner 106 can be operated to ensure that the gap time Tgla between the beginning of the first secondary pulse slice 3204a of set 3200a of pulse slices and the end of the primary pulse slice 3202a of the set 3200a of pulse slices is sufficient to allow the material of the dielectric structure 500 at or near the spot location to cool somewhat before the first secondary pulse slice 3204a is delivered, thereby avoiding undesirable modification of the material of the dielectric structure 500 at or near the spot location. The gap time Tglb between the beginning of the first secondary pulse slice 3204b of set 3200b of pulse slices and the end of the primary pulse slice 3202b of the set 3200b of pulse slices can be greater than, less than, or equal to the gap time Tgla.

As shown in FIG. 32, the first positioner 106 can also be operated to ensure that the gap time Tg2 between consecutively delivered secondary pulse slices 3204a of set 3200a of pulse slices is sufficient to maintain the material of the dielectric structure 500 at or near the spot location at a temperature sufficient to allow suitable processing of the dielectric structure 500 without undesirably damaging the surrounding material. The gap time between consecutively delivered secondary pulse slices 3204b of set 3200b of pulse slices can be greater than, less than, or equal to the gap time Tg2.

a. Sequential vs. Interleaved Deflection of Sets of Laser Pulses

Referring to FIG. 32, the first positioner 106 can be operated during punch processing to temporally-divide mother laser pulse 3201 into a plurality of sets 3200 of pulse slices, wherein the pulse slices within set 3200a of laser pulse slices are all deflected to the same (or at least substantially the same) angle within a primary angular range 116 before the pulse slices within set 3200b of laser pulse slices are deflected to a different angle. In this manner, the first positioner 106 is operated to deflect the sets 3200a and 3200b of laser pulse slices according to a sequential deflection technique. In other embodiments, the first positioner 106 can be operated to deflect the sets 3200a and 3200b of laser pulse slices according to an interleaved deflection technique. In an interleaved deflection technique, the first positioner 106 is operated during punch processing to temporally-divide mother laser pulse 3201 into a plurality of sets 3200 of pulse slices, wherein one or more pulse slices within sets 3200a and 3200b of laser pulse slices are alternately deflected between different angles within a primary angular range 116.

For example, referring to FIG. 33, the first positioner 106 can be operated according to an interleaved deflection technique in which the primary pulse slice 3202a is deflected by a first angle within the primary angular range 116 shown in FIG. 1 (or by a first angle within the first primary angular range 116a shown in FIG. 31), and then the primary pulse slice 3202b is deflected by a second angle within the primary angular range 116 shown in FIG. 1 (or by a first angle within the second primary angular range 116b shown in FIG. 31), and then the secondary pulse slices 3204a are deflected by the first angle within the primary angular range 116 shown in FIG. 1 (or by the first angle within the first primary angular range 116a shown in FIG. 31), and then the secondary pulse slices 3204b are deflected by the second angle within the primary angular range 116 shown in FIG. 1 (or by the first angle within the second primary angular range 116b shown in FIG. 31).

In another example, and with reference to FIG. 34, the first positioner 106 can be operated according to an interleaved deflection technique similar to the technique discussed with respect to FIG. 33, but the secondary pulse slices 3204a and 3204b are alternately deflected between the first and second angles within the primary angular range 116 shown in FIG. 1 (or between the first angles of the first and second primary angular ranges 116a and 116b shown in FIG. 31).

Taking into account the aforementioned gap times between pulse slices in a set of pulse slices, the total amount of time necessary to form a feature (e.g., a via or other opening) by punch processing can vary depending on whether the first positioner 106 is operated according to a sequential deflection technique or an interleaved deflection technique. For example, if the total amount of time necessary to form a feature using set 3200a of pulse slices is Ta, and the total amount of time necessary to form a feature using set 3200b of pulse slices is Tb (where Tb may be greater than, less than or equal to Ta), then the total amount of time necessary to form two features using sets 3200a and 3200b of pulse slices is Tt1 when the first positioner 106 is operated according to a sequential deflection technique (see, e.g., FIG. 32). However, using the interleaved deflection technique shown in FIG. 33, the total amount of time necessary to form the same two features using sets 3200a and 3200b of pulse slices is Tt2, which is less than Tt1. Note, in FIG. 33, the gap time Tglb' is shown to be greater than gap time Tglb, but may be made equal to gap time Tg1b by, for example, adjusting the pulse duration and/or power of the secondary pulse slices 3204a, by adjusting the gap time between primary pulse slice 3202b and the first secondary pulse slice 3204a, by adjusting the gap time Tg2 between secondary pulse slices 3204a, by adjusting the gap time between the last secondary pulse slice 3204a and the first secondary pulse slice 3204b, or the like or any combination thereof..

Likewise, using the interleaved deflection technique shown in FIG. 34, the total amount of time necessary to form the same two features using sets 3200a and 3200b of pulse slices is Tt2. Note, in FIG. 34, the gap time Tglb" is shown to be less than gap time Tglb, but may be made equal to gap time Tglb by, for example, adjusting the pulse duration and/or power of the first secondary pulse slice 3204a, by adjusting the gap time between primary pulse slice 3202b and the first secondary pulse slice 3204a, by adjusting the gap time Tg2 between secondary pulse slices 3204a, or the like or any combination thereof.

While embodiments have been discussed herein with respect to punch processing, it will be appreciated that these embodiments may also be applicable to form features using scan patterns (by scanning the process spot along any scan pattern exemplarily described herein, e.g., with respect to FIGS. 8 to 29, 47, 50 or 51, or otherwise).

b. Additional Examples Concerning Set of Laser Pulses

In the embodiments illustrated in FIGS. 32-34, each of the pulse slices in a set of pulse slices has a rectangular temporal power profile, and the peak optical power of any pulse slice in a set of pulse slices is the same as the peak optical power of all other pulse slices in the set of pulse slices. In another embodiment, one or more pulse slices in a set of pulse slices can have a temporal power profile of any other shape, the peak optical power of any pulse slice in a set of pulse slices can be different from the peak optical power of any other pulse slice in the set of pulse slices, or any combination thereof.

Further, in the illustrated in FIGS. 32-34, as between different sets of pulse slices, characteristics of the pulse slices (i.e., in terms of pulse energy, pulse duration, temporal power profile, number of pulse slices, gap time, etc.) within one set of pulse slices are the same as (or substantially the same as) characteristics of corresponding pulse slices within another set of pulse slices. Thus, the sets of pulse slices temporally-divided from a common mother pulse can be considered to be the same. In another embodiment, at least one characteristic of at least one pulse slice (e.g., in terms of pulse energy, pulse duration, temporal power profile, number of pulse slices, gap time, etc.) in one set of pulse slices is different from a characteristic of at least one corresponding pulse slice in another set of pulse slices. Thus, the sets of pulse slices temporally-divided from a common mother pulse can be considered to be different.

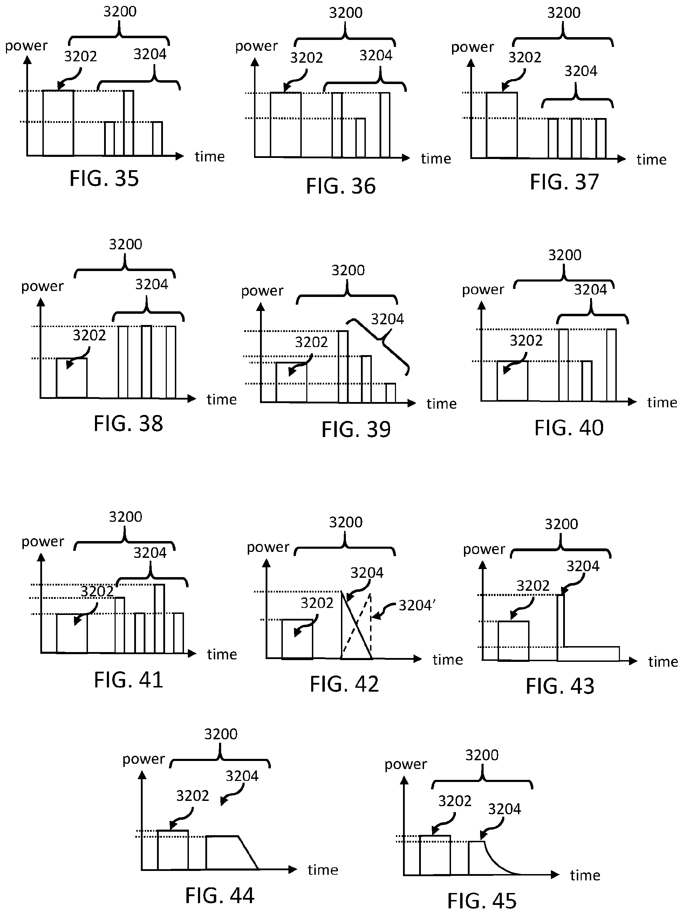

FIGS. 35-45 illustrate still other embodiments of exemplary sets of pulse slices that may be generated by operating the first positioner 106 during a punch process or during a process of scanning the process spot (e.g., by scanning a process spot along any of the aforementioned scan patterns as discussed herein, or otherwise) to form a feature (e.g., a via, such as a blind-via, a through-via, or other opening).

Referring to FIG. 42, the temporal power profile of the secondary pulse slice 3204 is continuously modulated (e.g., as shown by the downwardly-sloped line). In this case, the secondary pulse slice 3204 shown in FIG. 42 may be deflected by a single angle within a primary angular range 116 or may be deflected by multiple angles (e.g., over time) within a common primary angular range 116. In FIG. 42, reference numeral 3204' represents an alternative secondary pulse slice to alternative secondary pulse slice 3204 in which the temporal power profile is continuously modulated (e.g., to increase, instead of to decrease over time). FIGS. 44 and 45 illustrate alternative embodiments where the secondary pulse slice 3204 can have different continuously modulated temporal power profiles.

Referring to FIG. 43, the temporal power profile of the secondary pulse slice 3204 is modulated in a stepwise manner. In this case, the secondary pulse slice 3204 shown in FIG. 43 may be deflected by a single angle within a primary angular range 116 or may be deflected by multiple angles (e.g., over time) within a common primary angular range 116. As with the example shown in FIG. 42, the secondary pulse slice 3204 shown in FIG. 43 can be flipped (e.g., such that the secondary pulse slice 3204 has a relatively low optical power before being modulated to have a relatively high optical power).

IX. Conclusion

The foregoing is illustrative of embodiments and examples of the invention, and is not to be construed as limiting thereof. Although a few specific embodiments and examples have been described with reference to the drawings, those skilled in the art will readily appreciate that many modifications to the disclosed embodiments and examples, as well as other embodiments, are possible without materially departing from the novel teachings and advantages of the invention. Accordingly, all such modifications are intended to be included within the scope of the invention as defined in the claims.

**Claims**

1. A method of forming an opening within a metallic structure of a workpiece (102) comprising a dielectric structure and the metallic structure (502) on the dielectric structure (500), wherein the opening formed in the metallic structure exposes a portion of the dielectric structure, the method being **characterised by** the following steps:

   scanning a beam of laser energy (506) directed onto the workpiece such that the beam of laser energy is incident upon the metallic structure, wherein the scanning includes addressing, in sequence, a plurality of spot locations of a scan pattern by delivering the laser energy to each of the plurality of spot locations such that a distance between spot locations in pairs of consecutively-addressed spot locations of the plurality of spot locations is greater than a distance between spot locations in pairs of spatially-adjacent spot locations, wherein the laser energy is set and the scanning is performed such that:

   a first set of spot locations of the plurality of spot locations is addressed to heat a region of the metallic structure where the opening is to be formed and vaporize a portion of the dielectric structure adjacent to the heated region of the metallic structure, wherein the region of the metallic structure is heated before being ejected from the workpiece under the influence of a pressure of the vaporized dielectric structure and wherein the region of the metallic structure is heated such that at least substantially all of the metallic structure within the region is melted or a portion of the metallic structure surrounding a center of the region is melted without melting another portion of the metallic structure at the center of the region; and
one or more spot locations of the plurality of spot locations is addressed after the first set of spot locations is addressed to eject the heated region of the metallic structure from the workpiece under the influence of the pressure of the vaporized dielectric structure.

2. The method of claim 1, wherein the laser energy has a wavelength in the infrared range of the electromagnetic spectrum.

3. The method of claim 1, wherein the laser energy has a wavelength in the ultraviolet range of the electromagnetic spectrum.

4. The method of claim 1, wherein scanning the beam of laser energy includes delivering at least one laser pulse to each of the plurality of spot locations.

5. The method of claim 4, wherein scanning the beam of laser energy includes delivering only one laser pulse to at least one of the plurality of spot locations.

6. The method of claim 1, wherein scanning the beam of laser energy to deliver the laser energy comprises:

generating, at a laser source, a first laser pulse; and
temporally dividing the first laser pulse into a plurality of second laser pulses, wherein at least two of the plurality of second laser pulses have different pulse durations.

7. The method of claim 1, wherein scanning the beam of laser energy to deliver the laser energy comprises:
generating, at a laser source, a first laser pulse; and
temporally dividing the first laser pulse into a plurality of second laser pulses, wherein at least two of the plurality of second laser pulses have the same pulse duration.

8. The method of claim 6 or claim 7, wherein the pulse duration of at least one of the plurality of second laser pulses is less than or equal to 1 $\mu$s.

9. The method of claim 6 or claim 7, wherein at least two of the plurality of second laser pulses have different peak powers.

10. The method of claim 6 or claim 7, wherein at least two of the plurality of second laser pulses have the same peak power.

11. The method of claim 1, wherein a portion of the first structure is melted when the first structure is ejected from the workpiece.

12. The method of claim 11, wherein another portion of the first structure is unmelted when the first structure is ejected from the workpiece, wherein the unmelted portion is surrounded by the melted portion.

13. An apparatus for forming a feature within a workpiece comprising a first structure and a second structure, wherein the feature includes an opening formed in the first structure, the apparatus comprising:

a laser source operative to generate a beam of laser energy, wherein the beam of laser energy is propagatable along a beam path to be incident upon the first structure of the workpiece;
a positioner operative to deflect the beam path; and
the apparatus being further **characterised in that** it comprises:
a controller communicatively coupled to the positioner, wherein the controller is configured to control an operation of the positioner to perform the method as recited in any of claims 1 to 12, 15 or 16.

14. A controller for use with an apparatus for forming a feature within a workpiece comprising a first structure and a second structure, wherein the feature includes an opening formed in the first structure and wherein the apparatus includes a laser source operative to generate a beam of laser energy, wherein the beam of laser energy is propagatable along a beam path to be incident upon the first structure of the workpiece, and a positioner operative to deflect the beam path, the controller comprising:

a processor communicatively coupled to the positioner; and
the controller being further **characterised in that** it comprises:
memory accessible to the processor, wherein the memory has instructions stored thereon which, when executed by the processor, cause the processor to control an operation of the positioner to perform the method as recited in any of claims 1 to 12, 15 or 16.

**15.** The method of claim 1, wherein the laser energy has a wavelength in the green range of the electromagnetic spectrum.

**16.** The method of claim 1, wherein the beam of laser energy is a continuous or a quasi-continuous laser beam.

**Patentansprüche**

**1.** Verfahren zum Bilden einer Öffnung innerhalb einer metallischen Struktur eines Werkstücks (102), das eine dielektrische Struktur und die metallische Struktur (502) auf der dielektrischen Struktur (500) umfasst, wobei die in der metallischen Struktur gebildete Öffnung einen Abschnitt der dielektrischen Struktur freilegt, wobei das Verfahren durch die folgenden Schritte gekennzeichnet ist:
Abtasten eines Laserenergiestrahls (506), der auf das Werkstück so gerichtet ist, dass der Laserenergiestrahl auf die metallische Struktur auftrifft, wobei das Abtasten das aufeinanderfolgende Adressieren einer Vielzahl von Punktstellen eines Abtastmusters beinhaltet, indem die Laserenergie an jede aus der Vielzahl von Punktstellen so geliefert wird, dass ein Abstand zwischen Punktstellen in Paaren von aufeinanderfolgend adressierten Punktstellen aus der Vielzahl von Punktstellen größer als ein Abstand zwischen Punktstellen in Paaren von räumlich benachbarten Punktstellen ist, wobei die Laserenergie so eingestellt wird und das Abtasten so durchgeführt wird, dass:

ein erster Satz von Punktstellen aus der Vielzahl von Punktstellen dazu adressiert ist, einen Bereich der metallischen Struktur zu erwärmen, wo die Öffnung gebildet werden soll, und einen Abschnitt der dielektrischen Struktur benachbart zu dem erwärmten Bereich der metallischen Struktur zu verdampfen, wobei der Bereich der metallischen Struktur unter dem Einfluss eines Drucks der verdampften dielektrischen Struktur erwärmt wird, bevor er aus dem Werkstück ausgestoßen wird, und wobei der Bereich der metallischen Struktur so erwärmt wird, dass zumindest im Wesentlichen die gesamte metallische Struktur innerhalb des Bereichs geschmolzen wird oder ein Abschnitt der metallischen Struktur, der eine Mitte des Bereichs umgibt, geschmolzen wird, ohne einen anderen Abschnitt der metallischen Struktur in der Mitte des Bereichs zu schmelzen; und
eine oder mehrere Punktstellen aus der Vielzahl von Punktstellen adressiert wird, nachdem der erste Satz von Punktstellen dazu adressiert wurde, den erwärmten Bereich der metallischen Struktur unter dem Einfluss des Drucks der verdampften dielektrischen Struktur aus dem Werkstück auszustoßen.

**2.** Verfahren nach Anspruch 1, wobei die Laserenergie eine Wellenlänge im Infrarotbereich des elektromagnetischen Spektrums aufweist.

**3.** Verfahren nach Anspruch 1, wobei die Laserenergie eine Wellenlänge im Ultraviolettbereich des elektromagnetischen Spektrums aufweist.

**4.** Verfahren nach Anspruch 1, wobei das Abtasten des Laserenergiestrahls das Liefern von mindestens einem Laserimpuls an jede aus der Vielzahl von Punktstellen beinhaltet.

**5.** Verfahren nach Anspruch 4, wobei das Abtasten des Laserenergiestrahls das Liefern nur eines Laserimpulses an mindestens eine aus der Vielzahl von Punktstellen beinhaltet.

**6.** Verfahren nach Anspruch 1, wobei das Abtasten des Laserenergiestrahls zum Liefern der Laserenergie Folgendes umfasst:

Erzeugen eines ersten Laserimpulses an einer Laserquelle; und
zeitliches Aufteilen des ersten Laserimpulses in eine Vielzahl von zweiten Laserimpulsen, wobei mindestens zwei aus der Vielzahl von zweiten Laserimpulsen unterschiedliche Impulsdauern aufweisen.

**7.** Verfahren nach Anspruch 1, wobei das Abtasten des Laserenergiestrahls zum Liefern der Laserenergie Folgendes umfasst:

Erzeugen eines ersten Laserimpulses an einer Laserquelle; und
zeitliches Aufteilen des ersten Laserimpulses in eine Vielzahl von zweiten Laserimpulsen, wobei mindestens zwei aus der Vielzahl von zweiten Laserimpulsen die gleiche Impulsdauer aufweisen.

**8.** Verfahren nach Anspruch 6 oder Anspruch 7, wobei die Impulsdauer von mindestens einem aus der Vielzahl von zweiten Laserimpulsen kleiner als oder gleich 1 $\mu$s ist.

**9.** Verfahren nach Anspruch 6 oder Anspruch 7, wobei mindestens zwei aus der Vielzahl von zweiten Laserimpulsen unterschiedliche Spitzenleistungen aufweisen.

**10.** Verfahren nach Anspruch 6 oder Anspruch 7, wobei mindestens zwei aus der Vielzahl von zweiten Laserimpulsen die gleiche Spitzenleistung aufweisen.

**11.** Verfahren nach Anspruch 1, wobei ein Abschnitt der ersten Struktur geschmolzen wird, wenn die erste Struktur aus dem Werkstück ausgestoßen wird.

**12.** Verfahren nach Anspruch 111, wobei ein anderer Abschnitt der ersten Struktur ungeschmolzen ist, wenn die erste Struktur aus dem Werkstück ausgestoßen wird, wobei der ungeschmolzene Abschnitt von dem geschmolzenen Abschnitt umgeben ist.

**13.** Vorrichtung zum Bilden eines Merkmals innerhalb eines Werkstücks, das eine erste Struktur und eine zweite Struktur umfasst, wobei das Merkmal eine in der ersten Struktur ausgebildete Öffnung beinhaltet, wobei die Vorrichtung Folgendes umfasst:

eine Laserquelle, die betriebsfähig ist, um einen Laserenergiestrahl zu erzeugen, wobei sich der Laserenergiestrahl entlang eines Strahlenwegs ausbreiten kann, um auf die erste Struktur des Werkstücks aufzutreffen;
einen Positionierer, der dazu betriebsfähig ist, den Strahlweg abzulenken; und
wobei die Vorrichtung durch Folgendes gekennzeichnet ist:
ein Steuergerät, das kommunikativ mit dem Positionierer gekoppelt ist, wobei das Steuergerät dazu konfiguriert ist, einen Betrieb des Positionierers so zu steuern, dass er das Verfahren nach einem der Ansprüche 1 bis 12, 15 oder 16 durchführt.

**14.** Steuergerät zur Verwendung mit einer Vorrichtung zum Bilden eines Merkmals innerhalb eines Werkstücks, das eine erste Struktur und eine zweite Struktur umfasst, wobei das Merkmal eine in der ersten Struktur ausgebildete Öffnung beinhaltet und wobei die Vorrichtung eine Laserquelle, die dazu betriebsfähig ist, einen Laserenergiestrahl zu erzeugen, wobei sich der Laserenergiestrahl entlang eines Strahlenwegs ausbreiten kann, um auf die erste Struktur des Werkstücks aufzutreffen, und einen Positionierer beinhaltet, der dazu betriebsfähig ist, den Strahlenweg abzulenken, wobei das Steuergerät Folgendes umfasst:

einen Prozessor, der kommunikativ mit dem Positionierer gekoppelt ist; und
wobei das Steuergerät durch Folgendes gekennzeichnet ist:
einen Speicher, auf den der Prozessor zugreifen kann, wobei auf dem Speicher Anweisungen gespeichert sind, die, wenn sie durch den Prozessor ausgeführt werden, den Prozessor dazu veranlassen, einen Betrieb des Positionierers so zu steuern, dass er das Verfahren nach einem der Ansprüche 1 bis 12, 15 oder 16 durchführt.

**15.** Verfahren nach Anspruch 1, wobei die Laserenergie eine Wellenlänge im Grünbereich des elektromagnetischen Spektrums aufweist.

**16.** Verfahren nach Anspruch 1, wobei der Laserenergiestrahl ein kontinuierlicher oder ein quasi-kontinuierlicher Laserstrahl ist.

## Revendications

**1.** Procédé de formation d'une ouverture à l'intérieur d'une structure métallique d'une pièce (102) comprenant une structure diélectrique et la structure métallique (502) sur la structure diélectrique (500), dans lequel l'ouverture formée dans la structure métallique expose une partie de la structure diélectrique, le procédé étant **caractérisé par** les étapes suivantes :
le balayage d'un faisceau d'énergie laser (506) dirigé sur la pièce de sorte que le faisceau d'énergie laser soit incident sur la structure métallique, dans lequel le balayage comprend l'adressage, en séquence, d'une pluralité d'emplacements de points d'un motif de balayage en délivrant l'énergie laser à chacun de la pluralité d'emplacements de points de sorte qu'une distance entre les emplacements de points dans des paires d'emplacements de points adressés consécutivement de la pluralité d'emplacements de points soit supérieure à une distance entre les emplacements de points dans des paires d'emplacements de points spatialement adjacents, dans lequel l'énergie laser est réglée et le balayage est effectué de sorte que :

un premier ensemble d'emplacements de points de la pluralité d'emplacements de points soit adressé pour chauffer une région de la structure métallique où l'ouverture doit être formée et pour vaporiser une partie de la structure diélectrique adjacente à la région chauffée de la structure métallique, dans lequel la région de la structure métallique est chauffée avant d'être éjectée de la pièce sous l'influence d'une pression de la structure diélectrique vaporisée et dans lequel la région de la structure métallique est chauffée de sorte qu'au moins sensiblement toute la structure métallique dans la région soit fondue ou qu'une partie de la structure métallique entourant un centre de la région soit fondue sans faire fondre une autre partie de la structure métallique au centre de la région ; et
un ou plusieurs emplacements de points de la pluralité d'emplacements de points soient adressés après que le premier ensemble d'emplacements de points est adressé pour éjecter la région chauffée de la structure métallique de la pièce sous l'influence de la pression de la structure diélectrique vaporisée.

2. Procédé de la revendication 1, dans lequel l'énergie laser comporte une longueur d'onde dans la plage infrarouge du spectre électromagnétique.

3. Procédé de la revendication 1, dans lequel l'énergie laser comporte une longueur d'onde dans la plage ultraviolette du spectre électromagnétique.

4. Procédé de la revendication 1, dans lequel le balayage du faisceau d'énergie laser comprend la délivrance d'au moins une impulsion laser à chacun de la pluralité d'emplacements de points.

5. Procédé de la revendication 4, dans lequel le balayage du faisceau d'énergie laser comprend la délivrance d'uniquement une impulsion laser à au moins l'un de la pluralité d'emplacements de points.

6. Procédé de la revendication 1, dans lequel le balayage du faisceau d'énergie laser pour délivrer l'énergie laser comprend :

   la génération, au niveau d'une source laser, d'une première impulsion laser ; et
   la division temporelle de la première impulsion laser en une pluralité de secondes impulsions laser, dans lequel au moins deux de la pluralité de secondes impulsions laser comportent des durées d'impulsion différentes.

7. Procédé de la revendication 1, dans lequel le balayage du faisceau d'énergie laser pour délivrer l'énergie laser comprend :

   la génération, au niveau d'une source laser, d'une première impulsion laser ; et
   la division temporelle de la première impulsion laser en une pluralité de secondes impulsions laser, dans lequel au moins deux de la pluralité de secondes impulsions laser comportent la même durée d'impulsion.

8. Procédé de la revendication 6 ou de la revendication 7, dans lequel la durée d'impulsion d'au moins l'une de la pluralité de secondes impulsions laser est inférieure ou égale à 1 μs.

9. Procédé de la revendication 6 ou de la revendication 7, dans lequel au moins deux de la pluralité de secondes impulsions laser comportent des puissances de crête différentes.

10. Procédé de la revendication 6 ou de la revendication 7, dans lequel au moins deux de la pluralité de secondes impulsions laser comportent la même puissance de crête.

11. Procédé de la revendication 1, dans lequel une partie de la première structure est fondue lorsque la première structure est éjectée de la pièce.

12. Procédé de la revendication 11, dans lequel une autre partie de la première structure est non fondue lorsque la première structure est éjectée de la pièce à travailler, dans lequel la partie non fondue est entourée par la partie fondue.

13. Appareil pour former une caractéristique à l'intérieur d'une pièce comprenant une première structure et une seconde structure, dans lequel la caractéristique comprend une ouverture formée dans la première structure, l'appareil comprenant :

   une source laser servant à générer un faisceau d'énergie laser, dans lequel le faisceau d'énergie laser peut être propagé le long d'un trajet de faisceau pour être incident sur la première structure de la pièce ;
   un positionneur servant à dévier le trajet du faisceau ; et
   l'appareil étant **caractérisé par** :
   un dispositif de commande couplé en communication au positionneur, dans lequel le dispositif de commande est configuré pour commander une opération du positionneur pour réaliser le procédé selon l'une quelconque des revendications 1 à 12, 15 ou 16.

14. Dispositif de commande destiné à être utilisé avec un appareil pour former une caractéristique à l'intérieur d'une pièce comprenant une première structure et une seconde structure, dans lequel la caractéristique comprend une ouverture formée dans la première structure et dans lequel l'appareil comprend une source laser servant à générer un faisceau d'énergie laser, dans lequel le faisceau d'énergie laser peut être propagé le long d'un trajet de faisceau pour être incident sur la première structure de la pièce, et un positionneur opérationnel pour dévier le trajet de faisceau, le dispositif de commande comprenant :

   un processeur couplé en communication au positionneur ; et
   le dispositif de commande étant **caractérisé par** :
   une mémoire accessible au processeur, dans lequel la mémoire comporte des instructions stockées sur celle-ci qui, lorsqu'elles sont exécutées par le processeur, amènent le processeur à commander une opération du positionneur pour réaliser le procédé selon l'une quelconque des revendications 1 à 12, 15 ou 16.

15. Procédé de la revendication 1, dans lequel l'énergie laser comporte une longueur d'onde dans la plage verte du spectre électromagnétique.

16. Procédé de la revendication 1, dans lequel le faisceau d'énergie laser est un faisceau laser continu ou quasi continu.

FIG. 1

FIG. 2

FIG. 3

FIG. 4

FIG. 5

FIG. 6

FIG. 7

FIG. 8

FIG. 9

**FIG. 10**

**FIG. 11**

**FIG. 12**

**FIG. 13**

**FIG. 14**

**FIG. 15**

**FIG. 16**

**FIG. 17**

**FIG. 18**

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31

FIG. 32

FIG. 33

FIG. 34

FIG. 35

FIG. 36

FIG. 37

FIG. 38

FIG. 39

FIG. 40

FIG. 41

FIG. 42

FIG. 43

FIG. 44

FIG. 45

FIG. 46

FIG. 47

FIG. 48

FIG. 49

FIG. 50

FIG. 51

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017044646 A
- US 5751585 A
- US 5798927 A
- US 5847960 A
- US 6606999 B
- US 7605343 B
- US 8680430 B
- US 8847113 B
- US 20140083983
- US 4912487 A
- US 5633747 A
- US 5638267 A
- US 5917300 A
- US 6314463 B
- US 6430465 B
- US 6600600 B
- US 6606998 B
- US 6816294 B
- US 6947454 B
- US 7019891 B
- US 7027199 B
- US 7133182 B
- US 7133186 B
- US 7133187 B
- US 7133188 B
- US 7244906 B
- US 7245412 B
- US 7259354 B
- US 7611745 B
- US 7834293 B
- US 8026158 B
- US 8076605 B
- US 8288679 B
- US 8404998 B
- US 8497450 B
- US 8648277 B
- US 8896909 B
- US 8928853 B
- US 9259802 B
- US 20140026351
- US 20140196140 A
- US 20140263201 A
- US 20140263212 A
- US 20140263223 A
- US 20140312013 A
- DE 102013201968 B4
- WO 2009087392 A
- WO 2017044646 A1
- WO 2019060590 A1